# EUROPÄISCHE PATENTSCHRIFT

(11) **EP 3 255 688 B1**
(45) Veröffentlichungstag und Bekanntmachung des Hinweises auf die Patenterteilung: **03.10.2018**
(21) Anmeldenummer: 17174031.9
(22) Anmeldetag: 01.06.2017
(51) Int. Cl.: H01L 35/30, F01N 5/02, H01L 35/32

(54) **THERMOELEKTRISCHER GENERATOR FÜR ABGASANLAGEN UND KONTAKTELEMENT FÜR EINEN THERMOELEKTRISCHEN GENERATOR**
THERMOELECTRIC GENERATOR FOR EXHAUST SYSTEMS AND CONTACT MEMBER FOR A THERMOELECTRIC GENERATOR
GÉNÉRATEUR THERMOÉLECTRIQUE POUR SYSTÈME D'ÉCHAPPEMENT ET ÉLÉMENT DE CONTACT POUR UN GÉNÉRATEUR THERMOÉLECTRIQUE

(30) Priorität: 09.06.2016 DE 102016110625
(43) Veröffentlichungstag der Anmeldung: 13.12.2017
(73) Patentinhaber: Eberspächer Exhaust Technology GmbH & Co. KG, 66539 Neunkirchen (DE)
(72) Erfinder: Gaiser, Gerd, 72768 Reutlingen (DE); Frobenius, Fabian, 73728 Esslingen (DE); Hense, Matthias, 73630 Remshalden (DE)
(74) Vertreter: Diehl & Partner GbR

(56) Entgegenhaltungen:
- WO-A2-2008/155406
- DE-A1-102009 048 192
- US-A- 4 065 936
- US-A1- 2002 139 123
- US-A1- 2005 217 714
- US-A1- 2011 239 635

## Beschreibung

Die vorliegende Erfindung betrifft einen thermoelektrischen Generator, der dazu geeignet ist, die in einem warmen Fluid (beispielsweise im Abgas eines verbrennungsmotorisch betriebenen Fahrzeugs) enthaltene thermische Energie zumindest teilweise in elektrische Energie umzuwandeln. Auf diese Weise wird in Systemen, in welchen die im warmen Fluid enthaltene thermische Energie als Verlust anfällt, der Gesamtwirkungsgrad des Systems erhöht. Im Falle eines Fahrzeugs werden im Ergebnis der Kraftstoffverbrauch und die Emissionen pro gefahrenem Kilometer gesenkt. Weiter betrifft die vorliegende Erfindung ein Kontaktelement für einen solchen thermoelektrischen Generator.

Ein thermoelektrischer Generator (TEG) wandelt Wärme (konkret einen den thermoelektrischen Generator durchsetzenden Wärmestrom) direkt in elektrische Energie um. Hierfür ist ein thermoelektrischer Generator aus mehreren Thermoelementen (diese werden häufig auch als "thermoelektrische Module" bezeichnet) (TEM) aufgebaut, die zwischen einer kalten Seite und einer warmen Seite des thermoelektrischen Generators montiert und elektrisch in Reihe und/oder parallel geschaltet sind. In den Thermoelementen erfolgt die eigentliche Umwandlung von thermischer Energie in elektrische Energie. Diese Umwandlung kann auf unterschiedlichen Effekten (z. B. Seebeck-Effekt und Thomson-Effekt) beruhen. Zur Vermittlung einer Wärmeleitung zwischen der kalten bzw. warmen Seite und den Thermoelementen weist der thermoelektrische Generator häufig ein oder mehrere Kontaktelemente aus einem Material hoher thermischer Leitfähigkeit auf. Derartige Kontaktelemente dienen insbesondere dazu, Oberflächenunebenheiten auszugleichen und so eine Wärmeleitung über die ganze Fläche der Thermoelemente zu ermöglichen.

Dabei ist ein Einsatztemperaturbereich, innerhalb dessen bekannte Thermoelemente einen akzeptablen Wirkungsgrad aufweisen, relativ schmal. Innerhalb des Einsatztemperaturbereichs wird der Wirkungsgrad der Thermoelemente von der Temperaturdifferenz zwischen kalter Seite und warmer Seite bestimmt. Der Wirkungsgrad bestimmt u.a. die von einem Thermoelement bereitgestellte (elektrische) Spannung. Gebräuchliche Thermoelemente bestehen im Wesentlichen aus Bi₂Te₃, PbTe, SiGe, BiSb oder FeSi₂.

Bei der Verwendung eines thermoelektrischen Generators ist es wichtig, die empfindlichen (insbesondere drucksensiblen) Thermoelemente so in den Fluidstrom (z. B. Abgasstrang eines verbrennungsmotorisch betriebenen Fahrzeugs) zu integrieren, dass an den Flächen der Thermoelemente eine maximal nutzbare Temperaturdifferenz anliegt. Gleichzeitig soll der Gegendruck für das Fluid nicht oder nur geringfügig erhöht werden, da ein erhöhter Gegendruck auch die für den Transport des Fluids erforderliche Energie (und damit bei einem verbrennungsmotorisch betriebenen Fahrzeug den Kraftstoffverbrauch) erhöht. Schließlich sollen die Thermoelemente möglichst in einem Einsatztemperaturbereich betrieben werden, indem sie einen akzeptablen Wirkungsgrad aufweisen. Die Lösung dieser Probleme wird bei einer Verwendung in Fahrzeugen durch die engen Bauräume im oder unter Fahrzeugen zusätzlich erschwert.

Die Verwendung von thermoelektrischen Generatoren in Abgasanlagen verbrennungsmotorisch betriebener Fahrzeuge ist aus dem Stand der Technik bekannt. Exemplarisch wird auf die EP 1 475 532 A2, die JP H07-012009 A und die WO 2009/138158 A1 verwiesen.

Aus der WO 2009/138158 A1 ist bekannt, die kalte Seite der verwendeten thermoelektrischen Generatoren mit einem Kühlmittelkreislauf in Verbindung zu bringen und so zu kühlen. Weiter ist es aus der WO 2009/138158 A1 bekannt, die Wärmeaufnahme aus dem heißen Abgas an der warmen Seite der verwendeten thermoelektrischen Generatoren durch Rippen zu erhöhen. Dabei soll die Rippendichte oder der verwendete Rippentyp entlang der Strömungsrichtung verschieden sein, so dass sich für Thermoelemente stromaufwärts des heißen Abgasstromes eine niedrigere Wärmeleitfähigkeit als für Thermoelemente stromabwärts des heißen Abgasstromes ergibt.

WO 2008/155406 A2 offenbart einen thermoelektrischen Generator zur Umwandlung thermischer Energie in elektrische Energie. Die p-dotierten und n-dotierten Schenkel der einzelnen modulartig zusammengeschalteten Peltierelemente des Generators sind im Sinne einer Optimierung des Wirkungsgrades der Umsetzung der thermischen Energie in elektrische Energie aus unterschiedlichen Materialien hergestellt.

Bei vorbekannten Systemen ist es nachteilig, dass häufig mehrere für unterschiedliche Einsatztemperaturbereiche ausgelegte thermoelektrische Generatoren in Verbindung mit Bypässen für das warme Fluid verwendet werden, um bei Schwankungen der Temperatur des warmen Fluids insgesamt einen breiten Temperaturbereich des warmen Fluids nutzen zu können. Bypässe weisen aber einen großen Platzbedarf auf und sind aufgrund der Mehrzahl an verwendeten thermoelektrischen Generatoren teuer.

Weiter besteht bei vorbekannten Systemen häufig das Problem, dass in Strömungsrichtung des warmen Fluids hintereinander angeordnete Thermoelemente eines thermoelektrischen Generators aufgrund der dem warmen Fluid entzogenen thermischen Energie mit unterschiedlichen Temperaturdifferenzen beaufschlagt werden. Dies hat zur Folge, dass die Thermoelemente unterschiedlich hohe elektrische Spannungen erzeugen (und unterschiedliche Leistung bereitstellen), was einen komplizierten Aufbau einer nachfolgenden Leistungselektronik bedingt.

Zudem tritt bei vorbekannten Systemen das Problem auf, dass eine thermische Überlastung der stromaufwärts des warmen Fluids angeordneten Thermoelemente eines thermoelektrischen Generators vermieden werden muss.

Schließlich ist die Montage eines thermoelektrischen Generators aufgrund der Vielzahl von Komponenten (Thermoelemente und Kontaktelemente) aufwendig.

Ausgehend hiervon ist es Aufgabe der vorliegenden Erfindung, einen kompakten thermoelektrischen Generator für die Umwandlung von in einem Fluid enthaltener thermischer Energie in elektrische Energie bereitzustellen, der einen besonders breiten Einsatztemperaturbereich aufweist und leicht hergestellt werden kann.

Es ist eine weitere Aufgabe der vorliegenden Erfindung, einen kompakten thermoelektrischen Generator für die Umwandlung von in einem Fluid enthaltener thermischen Energie in elektrische Energie bereitzustellen, bei dem alle den thermoelektrischen Generator bildenden Thermoelemente mit einen im wesentlichen gleichen Wärmestrom beaufschlagt werden. Dabei ist unter einem im wesentlichen gleichen Wärmestrom ein Wärmestrom zu verstehen, bei dem die Leistung des Wärmestroms, mit dem die einzelnen Thermoelemente beaufschlagt werden, um weniger als 20 % und insbesondere um weniger als 10 % voneinander abweicht. In der Folge weisen die Thermoelemente auch eine im Wesentlichen gleiche Leistung auf.

Schließlich ist es eine weitere Aufgabe der vorliegenden Erfindung, einen kompakten thermoelektrischen Generator für die Umwandlung von in einem Fluid enthaltener thermischen Energie in elektrische Energie bereitzustellen, bei welchem eine thermische Überlastung der stromaufwärts des warmen Fluids angeordneten Thermoelemente vermieden wird.

Eine weitere Aufgabe der vorliegenden Erfindung ist es, für einen derartigen thermoelektrischen Generator ein geeignetes Kontaktelement zur Verfügung zu stellen, welches den Montageaufwand vereinfacht.

Die vorstehende Aufgabe wird durch die Kombination der Merkmale der unabhängigen Ansprüche gelöst. Bevorzugte Weiterbildungen finden sich in den abhängigen Ansprüchen.

Ausführungsformen eines thermoelektrischen Generators weisen einen ersten Strömungskanal zum Führen eines warmen Fluids, einen zweiten Strömungskanal zum Führen eines kalten Fluids, eine Mehrzahl von Thermoelementen, die zwischen dem ersten Strömungskanal und dem zweiten Strömungskanal angeordnet sind, ein zwischen der Mehrzahl von Thermoelementen und einer Wandung des ersten Strömungskanals angeordnetes erstes Kontaktelement und ein zwischen der Mehrzahl von Thermoelementen und einer Wandung des zweiten Strömungskanals angeordnetes zweites Kontaktelement auf. Der erste Strömungskanal weist einen Einlass und einen Auslass auf, welche eine erste Strömungsrichtung für das warme Fluid festlegen. Das warme Fluid dringt somit über den Einlass des ersten Strömungskanals in den ersten Strömungskanal ein und verlässt den ersten Strömungskanal über seinen Auslass. Entsprechend weist auch der zweite Strömungskanal einen Einlass und einen Auslass auf, welche eine zweite Strömungsrichtung für das kalte Fluid festlegen. Das kalte Fluid dringt somit über den Einlass des zweiten Strömungskanals in den zweiten Strömungskanal ein und verlässt den zweiten Strömungskanal über seinen Auslass. Mehrere Thermoelemente der Mehrzahl von Thermoelementen sind so zwischen dem ersten Strömungskanal und dem zweiten Strömungskanal angeordnet, dass sie in der ersten Strömungsrichtung paarweise zueinander benachbart sind. Dabei können benachbarte Thermoelemente direkt aneinander angrenzen, oder voneinander beabstandet sein. Das zwischen der Mehrzahl von Thermoelementen und der Wandung des ersten Strömungskanals angeordnete erste Kontaktelement weist den einzelnen Thermoelementen zugeordnete Kontaktabschnitte auf, die eine wärmeleitende Verbindung zwischen dem jeweils zugehörigen Thermoelement und der Wandung des ersten Strömungskanals bereitstellen. Diese wärmeleitende Verbindung weist einen Wärmedurchgangswiderstand auf und kann eine Wärmeleitung begünstigen (bei vergleichsweise niedrigem Wärmedurchgangswiderstand) oder hemmen (bei vergleichsweise hohem Wärmedurchgangswiderstand). Entsprechend weist auch das zwischen der Mehrzahl von Thermoelementen und der Wandung des zweiten Strömungskanals angeordnete zweite Kontaktelement den einzelnen Thermoelementen zugeordnete Kontaktabschnitte auf, die eine wärmeleitende Verbindung zwischen dem jeweils zugehörigen Thermoelement und der Wandung des zweiten Strömungskanals bereitstellen. Diese wärmeleitende Verbindung weist einen Wärmedurchgangswiderstand auf und kann eine Wärmeleitung begünstigen (bei vergleichsweise niedrigem Wärmedurchgangswiderstand) oder hemmen (bei vergleichsweise hohem Wärmedurchgangswiderstand). Die Summe der Wärmedurchgangswiderstände derjenigen Kontaktabschnitte des ersten und zweiten Kontaktelements, welche einem ersten Thermoelement zugeordnet sind, das in der ersten Strömungsrichtung stromaufwärts eines zweiten Thermoelements (und damit näher am Einlass für das warme Fluid) angeordnet ist, ist größer als die Summe der Wärmedurchgangswiderstände derjenigen Kontaktabschnitte des ersten und zweiten Kontaktelements, die dem zweiten Thermoelement zugeordnet sind (welches von dem Einlass für das warme Fluid weiter beabstandet ist).

Dabei bedeutet in diesem Dokument das Adjektiv "warme" in Bezug auf das im ersten Strömungskanal geführte Fluid, dass das Fluid eine höhere Temperatur aufweist, als das im zweiten Strömungskanal geführte "kalte" Fluid.

Weiter bezeichnet in diesem Dokument der Begriff "Strömungskanal" allgemein einen eine Fluidströmung führenden Körper, wie beispielsweise eine Rohrleitung. Bevorzugt weist der die Fluidströmung führende Körper einen konstanten Querschnitt auf.

Der Begriff "Thermoelement" bezeichnet in diesem Dokument ein elektrisches Bauelement, welches eine direkte Wandlung von Wärme in elektrische Energie erlaubt.

Schließlich wird in diesem Dokument unter dem Begriff "Wärmedurchgangswiderstand" der Kehrwert aus dem Produkt des Wärmedurchgangskoeffizenten des jeweiligen Kontaktabschnitts des jeweiligen Kontaktelements und der Größe der Durchgangsfläche verstanden. Der Wärmedurchgangskoeffizent kann durch Bestimmung der über eine Zeitspanne durch den jeweiligen Kontaktabschnitt übertragenen Wärmemenge bestimmt werden, wobei als Temperaturdifferenz vor und hinter dem jeweiligen Kontaktabschnitt gemäß einer Ausführungsform die Temperaturdifferenz verwendet wird, bei welcher das zugehörige Thermoelement den größten Wirkungsgrad aufweist. Alternativ kann für die Bestimmung des Wärmedurchgangskoeffizenten eine Temperaturdifferenz von 800°C (warme Seite) und 300°C (kalte Seite) verwendet werden.

Mit dem vorstehend beschriebenen Aufbau ist es möglich, den thermoelektrischen Generator bei insgesamt höheren Temperaturen für das warme Fluid als im Stand der Technik zu betreiben, da eine thermische Überlastung von nahe beim Einlass des ersten Strömungskanals angeordneten Thermoelementen durch das bewusste Vorsehen eines entsprechend hohen Wärmedurchgangswiderstands für die den jeweiligen Thermoelementen zugehörigen Kontaktabschnitte des ersten Kontaktelements verhindert werden kann. In der Folge wird für den thermoelektrischen Generator auch ein besonders breiter Einsatztemperaturbereich ermöglicht, ohne dass hierfür Bypässe erforderlich sind.

Zudem kann bei entsprechender Anpassung der jeweiligen Summen der Wärmedurchgangswiderstände der Kontaktabschnitte des ersten und zweiten Kontaktelements, welche entlang der ersten Strömungsrichtung angeordneten Thermoelementen zugeordnet sind, an die Temperaturen, Strömungsgeschwindigkeiten und Wärmekapazitäten der warmen und kalten Fluide sichergestellt werden, dass die zwischen dem ersten Strömungskanal und dem zweiten Strömungskanal über das erste Thermoelement übertragene Wärmemenge (der Wärmestrom) in etwa gleich groß ist, wie die zwischen dem ersten Strömungskanal und dem zweiten Strömungskanal über das zweite Thermoelement (und jedes entlang der ersten Strömungsrichtung stromabwärts angeordnete Thermoelement) übertragene Wärmemenge. So ist es so möglich, jedes entlang der ersten Strömungsrichtung nacheinander angeordnete Thermoelement mit einer annähernd gleichen Temperaturdifferenz zu beaufschlagen und so im gleichen Wirkungsgradbereich zu betreiben. Dies führt zu einer annähernd gleich hohen Leistung der Thermoelemente. Weiter stellen die Thermoelemente dann eine annähernd gleich hohe elektrische Spannung bereit, was den Aufbau einer nachfolgenden Leistungselektronik erleichtert.

Gemäß einer Ausführungsform beruhen die unterschiedlichen Wärmedurchgangswiderstände des ersten Kontaktelements darauf, dass die Dicke des ersten Kontaktelements im Kontaktabschnitt zwischen dem ersten Thermoelement und dem ersten Strömungskanal größer als die Dicke des ersten Kontaktelements im Kontaktabschnitt zwischen dem zweiten Thermoelement (und optional jedem entlang der ersten Strömungsrichtung nachfolgend angeordneten Thermoelement) und dem ersten Strömungskanal ist. Dies bedingt allerdings auch unterschiedliche Abstände der Thermoelemente von dem ersten Strömungskanal. Das erste Thermoelement ist dann von der Wandung des ersten Strömungskanals weiter beabstandet, als entlang der ersten Strömungsrichtung stromabwärts angeordnete Thermoelemente.

Gemäß einer Ausführungsform beruhen die unterschiedlichen Wärmedurchgangswiderstände des ersten Kontaktelements darauf, dass das erste Kontaktelement im Kontaktabschnitt zwischen dem ersten Thermoelement und dem ersten Strömungskanal einen niedrigeren Gehalt an Stoffen mit einer hohen Wärmeleitfähigkeit als im Kontaktabschnitt zwischen dem zweiten Thermoelement (und optional jedem entlang der ersten Strömungsrichtung stromabwärts angeordneten Thermoelement) und dem ersten Strömungskanal aufweist. Somit unterscheidet sich die Materialzusammensetzung des ersten Kontaktelements in dem Kontaktabschnitt, welcher dem ersten Thermoelement zugeordnet ist, von der Materialzusammensetzung des ersten Kontaktelements im Kontaktabschnitt, der dem zweiten Thermoelement zugeordnet ist. Beispielsweise kann das erste Kontaktelement in dem Kontaktabschnitt, welcher dem ersten Thermoelement zugeordnet ist, einen höheren Gehalt an einem Material mit einer vergleichsweise niedrigen Wärmeleitfähigkeit aufweisen, als in dem Kontaktabschnitt, welcher dem zweiten Thermoelement zugeordnet ist.

Gemäß einer Ausführungsform beruhen die unterschiedlichen Wärmedurchgangswiderstände des ersten Kontaktelements darauf, dass die effektive Querschnittsfläche des ersten Kontaktelements im Kontaktabschnitt zwischen dem ersten Thermoelement und dem ersten Strömungskanal kleiner als die effektive Querschnittsfläche des ersten Kontaktelements im Kontaktabschnitt zwischen dem zweiten Thermoelement (und optional jedem entlang der ersten Strömungsrichtung stromabwärts angeordneten Thermoelement) und dem ersten Strömungskanal ist. Dabei wird die effektive Querschnittsfläche des ersten Kontaktelements gemäß einer Ausführungsform in der Mitte zwischen der Wandung des ersten Strömungskanals und dem zugehörigen Thermoelement bestimmt. Die effektive Querschnittsfläche kann beispielsweise durch Einbringen von Hohlräumen oder Ausnehmungen in den jeweiligen Kontaktabschnitt des ersten Kontaktelements beeinfluss werden, was auch unterschiedliche Dichten der Kontaktabschnitte des ersten Kontaktelements insgesamt zur Folge hat.

Gemäß einer Ausführungsform beruhen die unterschiedlichen Wärmedurchgangswiderstände des ersten Kontaktelements darauf, dass die Größe der Oberfläche des Kontaktabschnitts des ersten Kontaktelements, die sich mit dem ersten Thermoelement in Kontakt befindet, kleiner als die Größe der Oberfläche des Kontaktabschnitts des ersten Kontaktelements ist, die sich mit dem zweiten Thermoelement (oder optional jedem entlang der ersten Strömungsrichtung stromabwärts angeordneten Thermoelement) in Kontakt befindet. Beispielsweise können im Kontaktabschnitt des ersten Kontaktelements Ausnehmungen vorgesehen sein, welche das erste Kontaktelement in dem jeweiligen Kontaktabschnitt zwischen der Wandung des ersten Strömungskanals und dem zugehörigen Thermoelement vollständig durchdringen. Dann kann über die Anzahl und Größe der Ausnehmungen in dem jeweiligen Kontaktabschnitt des ersten Kontaktelements eine Einstellung des Wärmedurchgangswiderstandes erfolgen.

Gemäß Ausführungsformen können die unterschiedlichen Wärmedurchgangswiderstände des zweiten Kontaktelements in den Kontaktabschnitten ebenfalls auf einer oder auf mehreren der vorstehend im Zusammenhang mit dem ersten Kontaktelement erläuterten Maßnahmen beruhen:
So kann die Dicke des zweiten Kontaktelements im Kontaktabschnitt zwischen dem ersten Thermoelement und dem zweiten Strömungskanal verschieden von der Dicke des zweiten Kontaktelements im Kontaktabschnitt zwischen dem zweiten Thermoelement und dem zweiten Strömungskanal sein, was auch hier unterschiedliche Abstände der ersten und zweiten Thermoelemente von dem zweiten Strömungskanal bedingt. Alternativ oder zusätzlich kann das zweite Kontaktelement im Kontaktabschnitt zwischen dem ersten Thermoelement und dem zweiten Strömungskanal einen Gehalt an Stoffen mit einer hohen Wärmeleitfähigkeit aufweisen, der sich von einem Gehalt an Stoffen mit einer hohen Wärmeleitfähigkeit im Kontaktabschnitt zwischen dem zweiten Thermoelement und dem zweiten Strömungskanal unterscheidet, so dass sich die Materialzusammensetzung des zweiten Kontaktelements in dem Kontaktabschnitt, der dem ersten Thermoelement zugeordnet ist, von der Materialzusammensetzung des zweiten Kontaktelements in dem Kontaktabschnitt, der dem zweiten Thermoelement zugeordnet ist, unterscheidet. Alternativ oder zusätzlich kann die effektive Querschnittsfläche des zweiten Kontaktelements im Kontaktabschnitt zwischen dem ersten Thermoelement und dem zweiten Strömungskanal verschieden von der effektiven Querschnittsfläche des zweiten Kontaktelements im Kontaktabschnitt zwischen dem zweiten Thermoelement und dem zweiten Strömungskanal sein, wobei die effektive Querschnittsfläche des zweiten Kontaktelements auch hier gemäß einer Ausführungsform in der Mitte zwischen Wandung des zweiten Strömungskanals und dem zugehörigen Thermoelement bestimmt wird. Alternativ oder zusätzlich kann die Größe der Oberfläche des Kontaktabschnitts des zweiten Kontaktelements, die sich mit dem ersten Thermoelement in Kontakt befindet, verschieden von der Größe der Oberfläche des Kontaktabschnitts des zweiten Kontaktelements, die sich mit dem zweiten Thermoelement in Kontakt befindet, sein. Auch hier steht das zweite Thermoelement optional symbolisch für jedes dem ersten Thermoelement entlang der ersten Strömungsrichtung stromabwärts (nachfolgend) angeordnete Thermoelement.

Die vorstehenden Maßnahmen lassen sich leicht und kostengünstig realisieren und erlauben eine feine Abstimmung der jeweiligen Wärmedurchgangswiderstände.

Gemäß einer Ausführungsform weist wenigstens eines von dem ersten und zweiten Kontaktelement zwischen demjenigen Kontaktabschnitt, welcher dem ersten Thermoelement zugeordnet ist, und demjenigen Kontaktabschnitt, welcher dem zweiten Thermoelement zugeordnet ist, einen Trennungsbereich auf, in welchem der Wärmedurchgangswiderstand gegenüber dem mittleren Wärmedurchgangswiderstand der benachbarten Kontaktabschnitte um wenigstens das Fünffache und insbesondere um wenigstens das Zehnfache erhöht ist.

Gemäß einer Ausführungsform ist der Wärmedurchgangswiderstand des Kontaktelements im Trennungsbereich zwischen demjenigen Kontaktabschnitt, welcher dem ersten Thermoelement zugeordnet ist, und demjenigen Kontaktabschnitt, welcher dem zweiten Thermoelement zugeordnet ist, gegenüber dem mittleren Wärmedurchgangswiderstand der benachbarten Kontaktabschnitte des Kontaktelements um weniger als das Zehntausendfache und insbesondere um weniger als das Tausendfache und weiter insbesondere um weniger als das Hundertfache erhöht, so dass sich folgende mögliche Bereiche ergeben: fünffache Erhöhung ≤ Wärmedurchgangswiderstand im Trennungsbereich < zehntausendfache Erhöhung; fünffache Erhöhung ≤ Wärmedurchgangswiderstand im Trennungsbereich < tausendfache Erhöhung; fünffache Erhöhung ≤ Wärmedurchgangswiderstand im Trennungsbereich < hundertfache Erhöhung; zehnfache Erhöhung ≤ Wärmedurchgangswiderstand im Trennungsbereich < zehntausendfache Erhöhung; zehnfache Erhöhung ≤ Wärmedurchgangswiderstand im Trennungsbereich < tausendfache Erhöhung; zehnfache Erhöhung ≤ Wärmedurchgangswiderstand im Trennungsbereich < hundertfache Erhöhung.

Auf diese Weise kann ein unerwünschter Wärmestrom zwischen in Strömungsrichtung der jeweiligen Fluide benachbarten Thermoelementen über die jeweiligen Kontaktelemente reduziert oder ganz unterbunden werden.

Gemäß einer Ausführungsform weist das erste Kontaktelement in wenigstens einem Kontaktabschnitt wenigstens eine Aussparung auf, deren größte Ausdehnung in die erste Strömungsrichtung orientiert ist. Gemäß einer Ausführungsform handelt es sich bei der Ausnehmung um ein Langloch. Gemäß einer Ausführungsform weist das zweite Kontaktelement in wenigstens einem Kontaktabschnitt wenigstens eine Aussparung auf, deren größte Ausdehnung in die zweite Strömungsrichtung orientiert ist. Gemäß einer Ausführungsform handelt es sich bei der Ausnehmung um ein Langloch.

Auf diese Weise kann dem Wärmestrom, welcher die Kontaktabschnitte der jeweiligen Kontaktelemente durchsetzt, eine Vorzugsrichtung eingeprägt werden, die in Strömungsrichtung des jeweiligen Fluids verläuft. Dies erleichtert es, die Oberflächen der Thermoelemente in Strömungsrichtung des jeweiligen Fluids mit einer im Wesentlichen gleich hohen Temperatur zu beaufschlagen, da eine Wärmeleitung innerhalb der Kontaktelemente in Strömungsrichtung der jeweiligen Fluide innerhalb der Kontaktabschnitte nicht oder nicht wesentlich unterbunden wird.

Gemäß einer Ausführungsform weist das erste Kontaktelement zwischen demjenigen Kontaktabschnitt, welcher dem ersten Thermoelement zugeordnet ist, und demjenigen Kontaktabschnitt, welcher dem zweiten Thermoelement zugeordnet ist, wenigstens eine Aussparung auf, deren größte Ausdehnung quer zur ersten Strömungsrichtung orientiert ist. Gemäß einer Ausführungsform handelt es sich bei der Ausnehmung um ein Langloch. Gemäß einer Ausführungsform weist das zweite Kontaktelement zwischen demjenigen Kontaktabschnitt, welcher dem ersten Thermoelement zugeordnet ist, und demjenigen Kontaktabschnitt, welcher dem zweiten Thermoelement zugeordnet ist, wenigstens eine Aussparung auf, deren größte Ausdehnung quer zur zweiten Strömungsrichtung orientiert ist. Gemäß einer Ausführungsform handelt es sich bei der Ausnehmung um ein Langloch.

Auf diese Weise kann ein unerwünschter Wärmestrom zwischen in Strömungsrichtung der jeweiligen Fluide benachbarten Thermoelementen über die jeweiligen Kontaktelemente nahezu vollständig unterbunden werden.

Gemäß einer Ausführungsform ist der Wärmedurchgangswiderstand des ersten Kontaktelements in demjenigen Kontaktabschnitt, welcher dem ersten Thermoelement zugeordnet ist, größer als der Wärmedurchgangswiderstand des ersten Kontaktelements in demjenigen Kontaktabschnitt, welcher dem zweiten Thermoelement zugeordnet ist.

Auf diese Weise kann sichergestellt werden, dass eine thermische Überlastung der nahe am Einlass des ersten Strömungskanals für das warme Fluid angeordneten Thermoelemente vermieden wird.

Gemäß einer Ausführungsform ist der Wärmedurchgangswiderstand des zweiten Kontaktelements in demjenigen Kontaktabschnitt, welcher dem ersten Thermoelement zugeordnet ist, größer als der Wärmedurchgangswiderstand des zweiten Kontaktelements in demjenigen Kontaktabschnitt, welcher dem zweiten Thermoelement zugeordnet ist, wenn die erste Strömungsrichtung und die zweite Strömungsrichtung gleich orientiert sind, und ist der Wärmedurchgangswiderstand des zweiten Kontaktelements in demjenigen Kontaktabschnitt, welcher dem ersten Thermoelement zugeordnet ist, niedriger als der Wärmedurchgangswiderstand des zweiten Kontaktelements in demjenigen Kontaktabschnitt, welcher dem zweiten Thermoelement zugeordnet ist, wenn die erste Strömungsrichtung und die zweite Strömungsrichtung entgegengesetzt orientiert sind.

Gemäß einer Ausführungsform ist die Wandung des ersten Strömungskanals, an welcher das erste Kontaktelement angeordnet ist, glatt und frei von Kühlrippen. Gemäß einer alternativen Ausführungsform weist die Wandung des ersten Strömungskanals, an welcher das erste Kontaktelement angeordnet ist, Kühlrippen auf, die entlang der ersten Strömungsrichtung gleichmäßig verteilt angeordnet sind. Gemäß einer Ausführungsform ist die Wandung des zweiten Strömungskanals, an welcher das zweite Kontaktelement angeordnet ist, glatt und frei von Kühlrippen. Gemäß einer alternativen Ausführungsform weist die Wandung des zweiten Strömungskanals, an welcher das zweite Kontaktelement angeordnet ist, Kühlrippen auf, die entlang der zweiten Strömungsrichtung gleichmäßig verteilt angeordnet sind. Gemäß einer Ausführungsform sind die Kühlrippen auf derjenigen Seite der Wandung des jeweiligen Strömungskanals angeordnet, die mit dem Fluid und nicht mit dem jeweiligen Kontaktelement in Kontakt steht. Somit sind die Kühlrippen im Inneren des jeweiligen Strömungskanals angeordnet.

Die Verwendung von Strömungskanälen mit glatter Wandung und der Verzicht auf im Inneren der Strömungskanäle angeordnete Kühlrippen vermeidet eine Erhöhung des Strömungswiderstands für die in den Strömungskanälen geführten Fluide und vermeidet damit eine Reduzierung des Gesamtwirkungsgrades durch Strömungsverluste. Andererseits erhöht das Vorsehen von Kühlrippen die für eine Wärmeleitung zur Verfügung stehende Fläche. Dann stellt eine gleichmäßige Verteilung der Kühlrippen entlang der jeweiligen Strömungsrichtung sicher, dass die für den Wärmeübergang zur Verfügung stehende Fläche über die ganze Erstreckung des jeweiligen Strömungskanals etwa gleich groß ist. Auch der Strömungswiderstand ist dann über die ganze Erstreckung des jeweiligen Strömungskanals in etwa konstant.

Gemäß einer Ausführungsform stellt das erste Kontaktelement alle Kontaktabschnitte einstückig bereit. Gemäß einer Ausführungsform stellt das das zweite Kontaktelement alle Kontaktabschnitte einstückig bereit.

Eine einstückige Ausbildung der Kontaktelemente mit den zugehörigen Kontaktabschnitten erleichtert eine Montage des thermoelektrischen Generators, da die Zahl der verwendeten Teile gering gehalten wird. Zudem erlaubt eine einstückige Ausbildung der Kontaktelemente eine feste Vorgabe der Reihenfolge der Kontaktabschnitte.

Gemäß einer Ausführungsform sind die Mehrzahl von Thermoelementen einlagig zwischen dem ersten Strömungskanal und dem zweiten Strömungskanal angeordnet.

Gemäß einer Ausführungsform sind das erste Thermoelement und das zweite Thermoelement (d.h. entlang der ersten Strömungsrichtung benachbart angeordnete Thermoelemente) paarweise untereinander baugleich oder sind alle Thermoelemente der Mehrzahl von Thermoelementen untereinander baugleich.

Gemäß einer Ausführungsform ist das erste Kontaktelement eine Wärmeleitfolie aus Graphit oder Silikonkautschuk oder Polyimid oder Aluminiumoxid oder Kunstglimmer oder Acrylpolymer. Gemäß einer Ausführungsform ist das zweite Kontaktelement eine Wärmeleitfolie aus Graphit oder Silikonkautschuk oder Polyimid oder Aluminiumoxid oder Kunstglimmer oder Acrylpolymer.

Bei diesen Materialien lassen sich durch Einbringen von Löchern leicht Kontaktabschnitte mit unterschiedlicher Wärmedurchgangswiderstand bereitstellen.

Ausführungsformen des thermoelektrischen Generators sind frei von Bypassleitungen.

Ausführungsformen eines alternativen thermoelektrischen Generators weisen einen Strömungskanal mit einem Einlass und einem Auslass zum Führen eines Fluids auf, wobei der Einlass und der Auslass des Strömungskanals eine Strömungsrichtung für das Fluid festlegen. Der thermoelektrische Generator weist weiter eine Mehrzahl von Thermoelementen auf, die in der Strömungsrichtung zueinander benachbart neben dem Strömungskanal angeordnet sind. Weiter weist der thermoelektrische Generator ein zwischen der Mehrzahl von Thermoelementen und einer Wandung des Strömungskanals angeordnetes Kontaktelement auf, welches den einzelnen Thermoelementen zugeordnete Kontaktabschnitte aufweist, die eine wärmeleitende Verbindung zwischen dem jeweils zugehörigen Thermoelement und der Wandung des Strömungskanals bereitstellen. Dabei weist das Kontaktelement zwischen direkt benachbarten Kontaktabschnitten, welche direkt benachbarten Thermoelementen zugeordnet sind, einen Trennungsbereich auf, in welchem der Wärmedurchgangswiderstand gegenüber dem mittleren Wärmedurchgangswiderstand der direkt benachbarten Kontaktabschnitte um wenigstens das Fünffache und insbesondere um wenigstens das Zehnfache erhöht ist.

Gemäß einer Ausführungsform ist der Wärmedurchgangswiderstand des Kontaktelements im Trennungsbereich zwischen direkt benachbarten Kontaktabschnitten, welche direkt benachbarten Thermoelementen zugeordnet sind, gegenüber dem mittleren Wärmedurchgangs-widerstand der direkt benachbarten Kontaktabschnitte des Kontaktelements um weniger als das Zehntausendfache und insbesondere um weniger als das Tausendfache und weiter insbesondere um weniger als das Hundertfache erhöht, so dass sich folgende mögliche Bereiche ergeben: fünffache Erhöhung ≤ Wärmedurchgangswiderstand im Trennungsbereich < zehntausendfache Erhöhung; fünffache Erhöhung ≤ Wärmedurchgangswiderstand im Trennungsbereich < tausendfache Erhöhung; fünffache Erhöhung ≤ Wärmedurchgangswiderstand im Trennungsbereich < hundertfache Erhöhung; zehnfache Erhöhung ≤ Wärmedurchgangswiderstand im Trennungsbereich < zehntausendfache Erhöhung; zehnfache Erhöhung ≤ Wärmedurchgangswiderstand im Trennungsbereich < tausendfache Erhöhung; zehnfache Erhöhung ≤ Wärmedurchgangswiderstand im Trennungsbereich < hundertfache Erhöhung.

Durch Vorsehen eines derartigen Trennungsbereichs kann ein Wärmestrom zwischen benachbarten Thermoelementen über das Kontaktelement reduziert oder ganz unterbunden werden. Gleichzeitig wird durch Verwendung eines einstückigen Kontaktelementes der Montageaufwand reduziert.

Gemäß einer Ausführungsform sind dann die direkt benachbarten Thermoelemente für unterschiedliche Temperaturbereiche ausgelegt. Auf diese Weise kann eine thermische Überlastung von Thermoelementen vermieden werden, da auch über das Kontaktelement keine Wärmeleitung zwischen benachbarten Thermoelementen möglich ist.

Gemäß einer Ausführungsform weist das Kontaktelement zwischen demjenigen Kontaktabschnitt, welcher einem ersten Thermoelement zugeordnet ist, und demjenigen Kontaktabschnitt, welcher einem benachbarten zweiten Thermoelement zugeordnet ist, wenigstens eine Aussparung auf, deren größte Ausdehnung quer zur Strömungsrichtung orientiert ist. Gemäß einer Ausführungsform handelt es sich bei der Ausnehmung um ein Langloch.

Auf diese Weise kann ein unerwünschter Wärmestrom zwischen in Strömungsrichtung der jeweiligen Fluide benachbarten Thermoelementen über die jeweiligen Kontaktelemente nahezu vollständig unterbunden werden.

Ausführungsformen einer Abgasanlage für ein verbrennungsmotorisch betriebenes Fahrzeug weisen einen thermoelektrischen Generator wie vorstehend beschrieben auf, wobei der erste Strömungskanal eine Abgasleitung der Abgasanlage ist oder mit einer Abgasleitung der Abgasanlage verbindbar ist.

Ausführungsformen eines Kontaktelements für einen thermoelektrischen Generator weisen eine Mehrzahl von Kontaktabschnitten auf, die ausgebildet sind, eine wärmeleitende Verbindung zwischen einem jeweils zugehörigen angrenzenden Thermoelement eines thermoelektrischen Generator und einer angrenzenden Wandung eines Strömungskanals bereitzustellen. Dabei weist das Kontaktelement zwischen benachbarten Kontaktabschnitten, welche einander benachbarten Thermoelementen zugeordnet sind, einen Trennungsbereich auf, in welchem der Wärmedurchgangswiderstand gegenüber dem mittleren Wärmedurchgangswiderstand der benachbarten Kontaktabschnitte um wenigstens das Fünffache und insbesondere um wenigstens das Zehnfache erhöht ist. Dies kann beispielsweise durch Verwendung einer anderen Materialzusammensetzung für das Kontaktelement im Trennungsbereich erfolgen, oder dadurch, dass das Kontaktelement im Trennungsbereich eine Dichte oder Materialstärke aufweist, die geringer als in den benachbarten Kontaktabschnitten ist. Alternativ kann das Kontaktelement zwischen benachbarten Kontaktabschnitten, welche benachbarten Thermoelementen zugeordnet sind, auch eine Aussparung (oder mehrere Aussparungen) aufweisen, deren größte Ausdehnung in Richtung einer Trennungslinie zwischen benachbarten Kontaktabschnitten orientiert ist. Beispielsweise kann es sich bei der Aussparung um ein Langloch oder mehrere entlang einer Linie angeordnete (Kreis-)Löcher handeln.

Gemäß einer Ausführungsform ist der Wärmedurchgangswiderstand des Kontaktelements im Trennungsbereich zwischen benachbarten Kontaktabschnitten, welche einander benachbarten Thermoelementen zugeordnet sind, gegenüber dem mittleren Wärmedurchgangs-widerstand der benachbarten Kontaktabschnitte des Kontaktelements um weniger als das Zehntausendfache und insbesondere um weniger als das Tausendfache und weiter insbesondere um weniger als das Hundertfache erhöht, so dass sich folgende mögliche Bereiche ergeben: fünffache Erhöhung ≤ Wärmedurchgangswiderstand im Trennungsbereich < zehntausendfache Erhöhung; fünffache Erhöhung ≤ Wärmedurchgangswiderstand im Trennungsbereich < tausendfache Erhöhung; fünffache Erhöhung ≤ Wärmedurchgangswiderstand im Trennungsbereich < hundertfache Erhöhung; zehnfache Erhöhung ≤ Wärmedurchgangswiderstand im Trennungsbereich < zehntausendfache Erhöhung; zehnfache Erhöhung ≤ Wärmedurchgangswiderstand im Trennungsbereich < tausendfache Erhöhung; zehnfache Erhöhung ≤ Wärmedurchgangswiderstand im Trennungsbereich < hundertfache Erhöhung.

Auf diese Weise kann ein Wärmestrom zwischen benachbarten Thermoelementen über das Kontaktelement reduziert oder unterbunden werden.

Gemäß einer Ausführungsform weist das Kontaktelement die Form eines Rechtecks mit zwei parallelen langen Seiten und zwei parallelen kurzen Seiten auf, und ist zwischen benachbarten Kontaktabschnitten, welche benachbarten Thermoelementen zugeordnet sind, eine Aussparung vorgesehen, deren größte Ausdehnung parallel zu den kurzen Seiten des Kontaktelements orientiert ist.

Gemäß einer Ausführungsform stellt das Kontaktelement alle Kontaktabschnitte einstückig bereit.

Gemäß einer Ausführungsform ist das Kontaktelement eine Wärmeleitfolie aus Graphit oder Silikonkautschuk oder Polyimid oder Aluminiumoxid oder Kunstglimmer oder Acrylpolymer.

Weitere Merkmale der Erfindung ergeben sich aus der nachfolgenden Beschreibung von Ausführungsbeispielen in Verbindung mit den Ansprüchen sowie den Figuren. In den Figuren werden gleiche bzw. ähnliche Elemente mit gleichen bzw. ähnlichen Bezugszeichen bezeichnet. Es wird darauf hingewiesen, dass die Erfindung nicht auf die Ausführungsformen der beschriebenen Ausführungsbeispiele beschränkt, sondern durch den Umfang der beiliegenden Patentansprüche bestimmt ist. Insbesondere können die einzelnen Merkmale bei erfindungsgemäßen Ausführungsformen in anderer Anzahl und Kombination als bei den untenstehend angeführten Beispielen verwirklicht sein. Bei der nachfolgenden Erläuterung eines Ausführungsbeispiels der Erfindung wird auf die beiliegenden Figuren Bezug genommen, von denen
- Figur 1A: eine schematische perspektivische Ansicht eines thermoelektrischen Generators gemäß einer ersten Ausführungsform zeigt;
- Figur 1B: schematisch eine Schnittansicht durch den thermoelektrischen Generator aus Figur 1A zeigt;
- Figur 1C: schematisch eine Draufsicht auf erste und zweite Kontaktelemente zeigt, welchem im thermoelektrischen Generator aus Figur 1A verwendet werden;
- Figur 2A: eine schematische perspektivische Ansicht eines thermoelektrischen Generators gemäß einer zweiten Ausführungsform zeigt;
- Figur 2B: schematisch eine Schnittansicht durch den thermoelektrischen Generator aus Figur 2A zeigt;
- Figur 3A: eine schematische perspektivische Ansicht eines thermoelektrischen Generators gemäß einer dritten Ausführungsform zeigt;
- Figur 3B: schematisch eine Schnittansicht durch den thermoelektrischen Generator aus Figur 3A zeigt;
- Figur 3C: schematisch eine Draufsicht auf erste und zweite Kontaktelemente zeigt, welchem im thermoelektrischen Generator aus Figur 3A verwendet werden;
- Figur 4: eine schematische perspektivische Ansicht eines thermoelektrischen Generators gemäß einer vierten Ausführungsform zeigt;
- Figur 5: eine schematische perspektivische Ansicht eines thermoelektrischen Generators gemäß einer fünften Ausführungsform zeigt;
- Figur 6: schematisch eine Abgasanlage zeigt, welche den thermoelektrischen Generator gemäß der fünften Ausführungsform verwendet;
- Figur 7A: eine schematische perspektivische Ansicht eines thermoelektrischen Generators gemäß einer sechsten Ausführungsform zeigt;
- Figur 7B: schematisch eine Schnittansicht durch den thermoelektrischen Generator aus Figur 7A zeigt; und
- Figur 7C: schematisch eine Draufsicht auf erste und zweite Kontaktelemente zeigt, welchem im thermoelektrischen Generator aus Figur 7A verwendet werden.

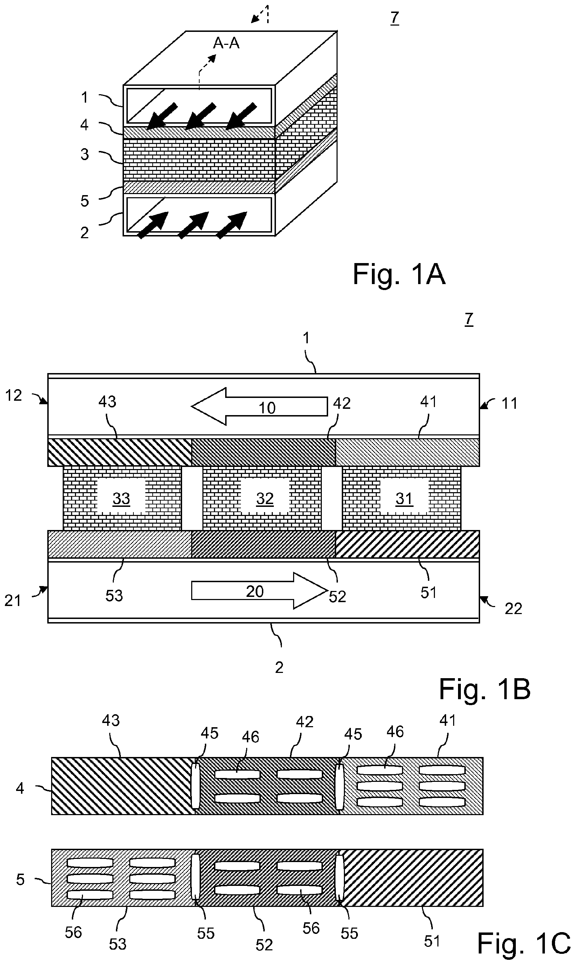

Im Folgenden wird unter Bezugnahme auf die Figuren 1A bis 1C eine erste Ausführungsform eines thermoelektrischen Generators 7 und zugehörigen Kontaktelements 4, 5 beschrieben. Dabei zeigt Figur 1B eine Querschnittsansicht durch den in Figur 1A perspektivisch gezeigten thermoelektrischen Generator entlang der Schnittlinie A-A und zeigt Figur 1C eine Draufsicht auf in dem thermoelektrischen Generator aus den Figuren 1A und 1B verwendete erste und zweite Kontaktelemente 4, 5.

Wie besonders gut aus den Figuren 1A und 1B ersichtlich, weist der thermoelektrische Generator 7 einen in den Figuren oben angeordneten ersten Strömungskanal 1 und einen in den Figuren unten angeordneten zweiten Strömungskanal 2 auf. Beide Strömungskanäle 1 und 2 sind in der gezeigten Ausführungsform aus Edelstahlblech gebildet und weisen jeweils einen konstanten rechteckigen Querschnitt auf.

Der obere erste Strömungskanal 1 wird in der gezeigten Ausführungsform entlang einer durch Pfeile symbolisierten ersten Strömungsrichtung 10 von einem 800°C warmen Abgasstrom durchströmt, welcher über einen in Figur 1B rechts angeordneten Einlass 11 in den ersten Strömungskanal 1 eintritt und den ersten Strömungskanal 1 über einen in Figur 1B links angeordneten Auslass 12 verlässt. Der untere zweite Strömungskanal 2 wird in der gezeigten Ausführungsform entlang einer durch Pfeile gekennzeichneten zweiten Strömungsrichtung 20 von einem 40°C warmen und damit relativ kalten Luftstrom durchströmt, welcher über einen in Figur 1B links angeordneten Einlass 21 in den zweiten Strömungskanal 2 eintritt und den zweiten Strömungskanal 2 über einen in Figur 1B rechts angeordneten Auslass 22 verlässt. Ersichtlich sind die erste Strömungsrichtung 10 und die zweite Strömungsrichtung 20 in der gezeigten Ausführungsform entgegengesetzt orientiert, so dass der im oberen ersten Strömungskanal 1 geführte warme Abgasstrom und der im unteren zweiten Strömungskanal 2 geführte kalte Luftstrom den thermoelektrischen Generator 7 im Gegenstrom durchströmen.

Zwischen den ersten und zweiten Strömungskanälen 1, 2 sind in einer Ebene 3 drei baugleiche Thermoelemente 31, 32 und 33 so angeordnet, dass sie entlang der ersten und zweiten Strömungsrichtung 10, 20 einlagig in einer Reihe benachbart angeordnet sind. Dabei besteht zwischen den unmittelbar benachbarten Thermoelementen 31 und 32 bzw. 32 und 33 jeweils ein kleiner Abstand. Die thermische Verbindung zwischen einer Wandlung des ersten Strömungskanals 1 und den in der Ebene 3 angeordneten Thermoelementen 31, 32 und 33 wird durch ein erstes Kontaktelement 4 bereitgestellt, bei welchem es sich in der vorliegenden Ausführungsform um eine Wärmeleitfolie aus Kunstglimmer handelt. Die thermische Verbindung zwischen den in der Ebene 3 angeordneten Thermoelementen 31, 32 und 33 und der Wandung des zweiten Strömungskanals 2 wird durch ein zweites Kontaktelement 5 hergestellt, bei welchem es sich in der vorliegenden Ausführungsform um eine Wärmeleitfolie aus Graphit handelt. Der Temperaturunterschied zwischen dem 800°C heißen Abgasstrom und dem 40°C kalten Luftstrom bewirkt zwischen den beiden Strömungskanälen 1, 2 einen das erste Kontaktelement 4, die Thermoelemente 31, 32 und 33 und das zweite Kontaktelement 5 durchsetzenden Wärmestrom.

Dabei weisen das erste Kontaktelement 4 und das zweite Kontaktelement 5 einen Wärmedurchgangswiederstand auf, der sich entlang der ersten und zweiten Strömungsrichtung 10, 20 ändert.

Wie besonders gut aus der Draufsicht auf die ersten und zweiten Kontaktelemente 4, 5 in Figur 1C ersichtlich, ist die das erste Kontaktelement 4 bildende Wärmeleitfolie aus Kunstglimmer durch zwei das erste Kontaktelement 4 in Dickenrichtung vollständig durchsetzende Langlöcher 45, deren größte Ausdehnung quer zur ersten Strömungsrichtung 10 orientiert ist, in drei Kontaktabschnitte 41, 42 und 43 unterteilt. Dabei stellen diese als Langlöcher 45 ausgebildeten Ausnehmungen sicher, dass die Wärmeleitfähigkeit des ersten Kontaktelements 4 zwischen den jeweils benachbarten Kontaktabschnitten 41 und 42 bzw. 42 und 43 nahe Null ist. Auch das von der Wärmeleitfolie aus Graphit gebildete zweite Kontaktelement 5 ist durch zwei voneinander entlang der zweiten Strömungsrichtung 20 beabstandet angeordnete Langlöcher 55, welche das zweite Kontaktelement 5 in Dickenrichtung vollständig durchsetzen, in drei voneinander thermisch isolierte Kontaktabschnitte 51, 52 und 53 unterteilt. Auch hier sind die als Langlöcher 55 ausgebildeten Ausnehmungen so orientiert, dass ihre größte Ausdehnung quer zur Strömungsrichtung 20 orientiert ist und so eine Wärmeleitung zwischen den jeweils benachbarten Kontaktabschnitten 51 und 52 bzw. 52 und 53 weitgehend unterbunden wird.

Ein Kontaktabschnitt 41, 42, 43, 51, 52, 53 des ersten und zweiten Kontaktelements 4, 5 ist jeweils einem Thermoelement 31, 32 und 33 zugeordnet. Dabei weisen das erste Kontaktelement 4 und das zweite Kontaktelement 5 in ihren jeweiligen Kontaktabschnitten 41, 42, 43, 51, 52, 53 unterschiedliche Wärmedurchgangswiderstände auf. Dies wird in der gezeigten Ausführungsform dadurch erreicht, dass das als Wärmeleitfolie aus Kunstglimmer ausgebildete erste Kontaktelement 4 in den Kontaktabschnitten 41 und 42 eine unterschiedliche Anzahl von jeweils als Langloch 46 ausgebildeten Ausnehmungen aufweist. Dabei ist die größte Ausdehnung der Langlöcher 46 entlang der ersten Strömungsrichtung 10 orientiert, um eine Wärmeleitung innerhalb des jeweiligen Kontaktabschnittes 41 und 42 entlang der ersten Strömungsrichtung 10 zu begünstigen. Aufgrund der größten Anzahl an Langlöchern 46 weist das erste Kontaktelement 4 im Kontaktabschnitt 41 die kleinste und im Kontaktabschnitt 43, welcher frei von Ausnehmungen ist, die größte effektive Querschnittsfläche auf. Zudem ist die mit dem ersten Thermoelement 31 in Kontakt befindliche Oberfläche des ersten Kontaktelements 4 im Kontaktabschnitt 41 am kleinsten und die mit dem dritten Thermoelement 33 im Kontaktabschnitt 43 in Kontakt befindliche Oberfläche am größten.

Entsprechend weist auch das als Wärmeleitfolie aus Graphit ausgebildete zweite Kontaktelement 5 in den Kontaktabschnitten 52 und 53 eine unterschiedliche Anzahl von jeweils als Langloch 56 ausgebildeten Ausnehmungen auf. Dies hat auch hier zur Folge, dass die effektive Querschnittsfläche und die Größe der mit dem ersten Thermoelement 31 in Kontakt befindlichen Oberfläche des zweiten Kontaktelements 5 im Kontaktabschnitt 51 am größten und im Kontaktabschnitt 53 am kleinsten ist.

Dabei sind die einem Thermoelement 31, 32, 33 zugeordneten Kontaktabschnitte 41 und 51, 42 und 52, 53 und 53 der ersten und zweiten Kontaktelemente 4, 5 hinsichtlich ihres jeweiligen Wärmedurchgangswiderstandes so aufeinander abgestimmt, dass die Summe der Wärmedurchgangswiderstände der Kontaktabschnitte 41 und 51 der ersten und zweiten Kontaktelemente 4 und 5, welche dem ersten Thermoelement 31 zugeordnet sind, größer als die Summe der Wärmedurchgangswiderstände der Kontaktabschnitte 42 und 52 der ersten und zweiten Kontaktelemente 4 und 5 ist, welche dem zweiten Thermoelement 32 zugeordnet sind, und die Summe der Wärmedurchgangswiderstände dieser Kontaktabschnitte 42 und 52, welche dem zweiten Thermoelement 32 zugeordnet sind, wiederum größer als die Summe der Wärmedurchgangswiderstände der Kontaktabschnitte 43 und 53 der ersten und zweiten Kontaktelemente 4 und 5 ist, welchen dem dritten Thermoelement 33 zugeordnet sind. Somit nimmt die Summe der Wärmedurchgangswiderstände der Kontaktabschnitte 41, 42, 43, 51, 52, 53 der ersten und zweiten Kontaktelemente 4 und 5 entlang der ersten Strömungsrichtung 10 ab. Diese Anpassung erfolgt sowohl über die Wahl des Materials, aus welchem die ersten und zweiten Kontaktelemente 4, 5 gebildet sind, als auch durch Anordnung, Größe und Anzahl der in die Kontaktabschnitte 41, 42, 52, 53 eingebrachten Ausnehmungen. Das bewusste Vorsehen eines relativ hohen Wärmedurchgangswiderstandes für das entlang der ersten Strömungsrichtung 10 am Nächsten zum Einlass 11 des ersten Strömungskanals 1 angeordneten ersten Thermoelements 31 hat zur Folge, dass dieses erste Thermoelement 31 gut vor einer thermischen Überlastung geschützt ist.

Da gleichzeitig der Wärmedurchgangswiderstand des zweiten Kontaktelements 5 in dem Kontaktabschnitt 51, welcher dem ersten Thermoelement 41 zugeordnet ist, niedriger als der Wärmedurchgangswiderstand des dem zweiten Thermoelement 32 zugeordneten zweiten Kontaktabschnittes 52 ist, wird gleichzeitig eine gute Wärmeleitung zwischen dem ersten Thermoelement 31 und der Wandung des zweiten Strömungskanals 2 sichergestellt, so dass die von dem ersten Thermoelement 31 übertragene Wärmemenge insgesamt gleich der von dem zweiten und dritten Thermoelement 32 und 33 übertragene Wärmemenge eingestellt werden kann.

Da in der gezeigten Ausführungsform die Kontaktabschnitte 41, 42 und 43 des ersten Kontaktelements 4 und die Kontaktabschnitte 51, 52 und 53 des zweiten Kontaktelements 5 jeweils einstückig bereitgestellt werden, ist eine Montage der Kontaktelemente 4, 5 mit den zugehörigen Kontaktabschnitten 41, 42, 43, 51, 52, 53 einfach. Weiter ist die Anordnung der Kontaktabschnitte 41, 42, 43, 51, 52, 53 mit den unterschiedlichen Wärmedurchgangswiderständen fest vorgegeben, so dass Fehler bei der Montage vermieden werden können.

In der gezeigten Ausführungsform ist die Innenwand beider Strömungskanäle 1, 2 auf ihrer den Thermoelementen 31, 32, 33 zugewandten/angrenzenden Seite glatt und damit frei von Kühlrippen, so dass der erste und der zweite Strömungskanal 1 und 2 jeweils einen sehr niedrigen Strömungswiderstand aufweisen.

Auch wenn in der in den Figuren 1A bis 1C gezeigten Ausführungsform das erste und das zweite Kontaktelement 4, 5 aus unterschiedlichen Materialien gebildet sind, ist die Erfindung hierauf nicht beschränkt. Alternativ können die ersten und zweiten Kontaktelemente 4 und 5 auch aus dem gleichen Material gebildet sein.

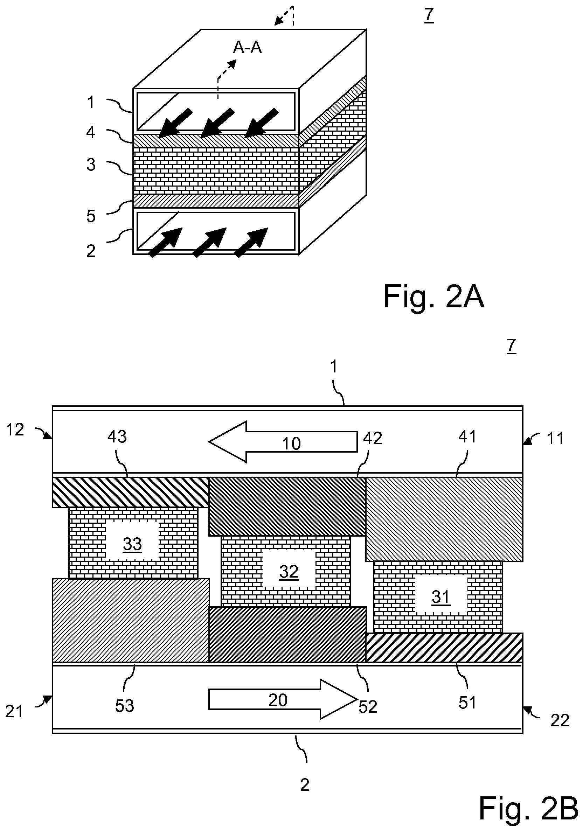

Im Folgenden wird unter Bezugnahme auf die Figuren 2A und 2B eine zweite Ausführungsform der vorliegenden Erfindung beschrieben. Dabei wird zur Vermeidung von Wiederholungen nur auf Unterschiede zu der in Verbindung mit den Figuren 1A bis 1C beschriebenen ersten Ausführungsform eingegangen. Auch hier zeigt die Figur 2B eine Querschnittsansicht entlang der Schnittlinie A-A durch die in Figur 2A schematisch perspektivisch gezeigte Ansicht des thermoelektrischen Generators 7.

Der thermoelektrische Generator 7 gemäß der zweiten Ausführungsform unterscheidet sich vom thermoelektrischen Generator 7 der vorstehend beschriebenen ersten Ausführungsform dadurch, dass die ersten und zweiten Kontaktelemente 4 und 5 gemäß der zweiten Ausführungsform jeweils frei von Ausnehmungen sind. Vielmehr werden die unterschiedlichen Wärmedurchgangswiderstände im dem ersten Thermoelement 31 zugeordneten Kontaktabschnitt 41 des ersten Kontaktelements 4, im dem zweiten Thermoelement 32 zugeordneten Kontaktabschnitt 42 des ersten Kontaktelements 4 und im dem dritten Thermoelement 33 zugeordneten Kontaktabschnitt 43 des ersten Kontaktelements 4 dadurch erzielt, dass die Dicke des ersten Kontaktelements 4 entlang der ersten Strömungsrichtung 10 abnimmt. Somit ist die Dicke des ersten Kontaktelements 4 im Kontaktabschnitt 41, welcher dem stromaufwärts der ersten Strömungsrichtung 10 als erstes angeordneten ersten Thermoelement 31 zugeordnet ist am größten und im Kontaktabschnitt 43, welcher dem entlang der ersten Strömungsrichtung 10 stromabwärts als letztes angeordneten dritten Thermoelement 33 zugeordnet ist, am kleinsten. Um gleichwohl einen konstanten Abstand zwischen den ersten und zweiten Strömungskanälen 1 und 2 sicherzustellen, verhalten sich die Dicken des zweiten Kontaktelements 5 in den Kontaktabschnitten 51, 52 und 53 genau umgekehrt zum ersten Kontaktelement 4.

In der Folge ist das entlang der ersten Strömungsrichtung 10 am weitesten stromaufwärts angeordnete erste Thermoelement 31 von einer Wandung des ersten Strömungskanals 1 am weitesten beabstandet und am nächsten zu einer Wandung des zweiten Strömungskanals 2 angeordnet und ist das entlang der ersten Strömungsrichtung 10 am weitesten stromabwärts angeordnete dritte Thermoelement 33 am nächsten zur Wandung des erstes Strömungskanals 1 angeordnet und von der Wandung des zweiten Strömungskanals 2 am weitesten beanstandet.

Um die unterschiedlichen Materialstärken des ersten und zweiten Kontaktelements 4 und 5 bereitzustellen, sind die beiden Kontaktelemente 4 und 5 in der gezeigten Ausführungsform aus Silikonkautschuk mit unterschiedlichen zugesetzten Mengen an Porzellankügelchen gebildet, welcher Silikonkautschuk auf die jeweiligen ersten und zweiten Strömungskanäle 1 und 2 gedruckt ist. Auch in dieser Ausführungsform sind benachbarte Thermoelemente 31 und 32 und 32 und 33 paarweise miteinander baugleich. Auch in dieser Ausführungsform nimmt die Summe der Wärmedurchgangswiderstände der einem Thermoelement 31, 32, 33 zugeordneten Kontaktabschnitte 41 und 51, 42 und 52, 43 und 53 entlang der ersten Strömungsrichtung 10 ab.

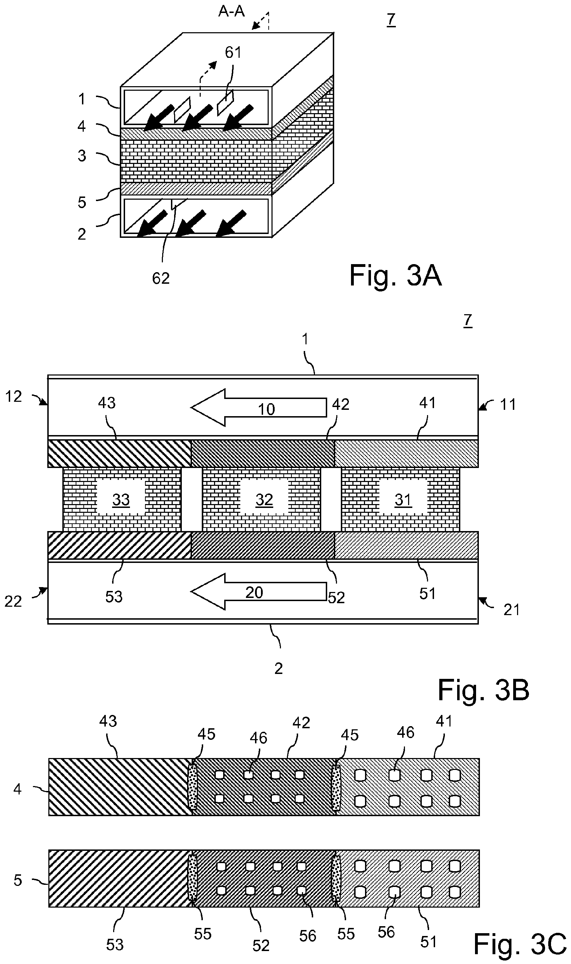

Im Folgenden wird unter Bezugnahme auf die Figuren 3A bis 3C eine dritte Ausführungsform eines thermoelektrischen Generators 7 und zugehörigen Kontaktelements 4, 5 beschrieben. Auch hier wird zur Vermeidung von unnötigen Wiederholungen auf die vorstehend beschriebenen Ausführungsformen Bezug genommen und nur auf Unterschiede näher eingegangen.

Wie besonders gut aus Figur 3A ersichtlich, weisen die Wandungen des ersten und zweiten Strömungskanals 1 und 2 in der hier gezeigten Ausführungsform auf Ihrer den Thermoelementen 31, 32, 33 zugewandten Seiten jeweils Kühlrippen 61 und 62 auf, die entlang der ersten Strömungsrichtung 10 und der zweiten Strömungsrichtung 20 jeweils gleichmäßig verteilt angeordnet sind. In der Folge weisen die Wandungen des ersten und zweiten Strömungskanals 1 und 2 eine größere Fläche auf, die für eine Wärmeübertragung zur Verfügung steht.

Anders als in den vorstehend beschriebenen ersten und zweiten Ausführungsformen sind in der dritten Ausführungsform die erste Strömungsrichtung 10 und die zweite Strömungsrichtung 20 in die gleiche Richtung orientiert, so dass der erste und zweite Strömungskanal 1 und 2 im Gleichstrom betrieben werden.

Dabei sind dem entlang der ersten und zweiten Strömungsrichtung 10, 20 am weitesten stromaufwärts angeordneten ersten Thermoelement 31 jeweils Kontaktabschnitte 41 und 51 der ersten und zweiten Kontaktelemente 4 und 5 zugeordnet, welche den höchsten Wärmedurchgangswiderstand aufweisen, und sind dem am weitesten stromabwärts angeordneten Thermoelement 33 jeweils Kontaktabschnitte 43 und 53 der ersten und zweiten Kontaktelemente 4 und 5 mit dem niedrigsten Wärmedurchgangswiderstand zugeordnet.

Wie gut aus Figur 3C ersichtlich, wird in dieser Ausführungsform der Wärmedurchgangswiderstand der ersten und zweiten Kontaktelemente 4 und 5, welche in dieser Ausführungsform jeweils aus Acrylpolymer gebildet sind, durch das Einbringen von Aussparungen 46 bzw. 56 eingestellt. Allerdings wird in der hier gezeigten Ausführungsform der Wärmedurchgangswiderstand nicht wie in der ersten Ausführungsform durch die Anzahl der Ausnehmungen 46 und 56 verändert, sondern durch die Größe der jeweiligen Ausnehmung 46 und 56.

Weiter werden in der dritten Ausführungsform die Kontaktabschnitte 41, 42 und 43 des ersten Kontaktelements 4 und die Kontaktabschnitte 51, 52 und 53 des zweiten Kontaktelements 5 - anders als in der ersten Ausführungsform - nicht durch Langlöcher sondern durch Bereiche 45 und 55 unterteilt, in welchen die ersten und zweiten Kontaktelemente 4 und 5 einen stark erhöhten Gehalt an einem Stoff mit geringer Wärmeleitfähigkeit aufweisen. In der gezeigten Ausführungsform ist dieser Stoff mit geringer Wärmeleitfähigkeit Aluminiumoxid. In der Folge ist der Wärmedurchgangswiderstand in den Bereichen 45 und 55 zwischen jeweils benachbarten Kontaktabschnitten 41 und 42 bzw. 42 und 43 und 51 und 52 bzw. 52 und 53 in der gezeigten Ausführungsform 11-fach höher, als der mittlere Wärmedurchgangswiderstand der jeweils angrenzenden Kontaktabschnitte.

Die in den Abschnitten 45 und 55 verwendete Technik einer Anpassung der Materialzusammensetzung zur Änderung des Wärmedurchgangswiderstands kann alternativ auch verwendet werden, um den Wärmedurchgangswiderstand der Kontaktabschnitte 41, 42 und 43 des ersten Kontaktelements 4 und/oder der Kontaktabschnitte 51, 52 und 53 des zweiten Kontaktelements 5 einzustellen.

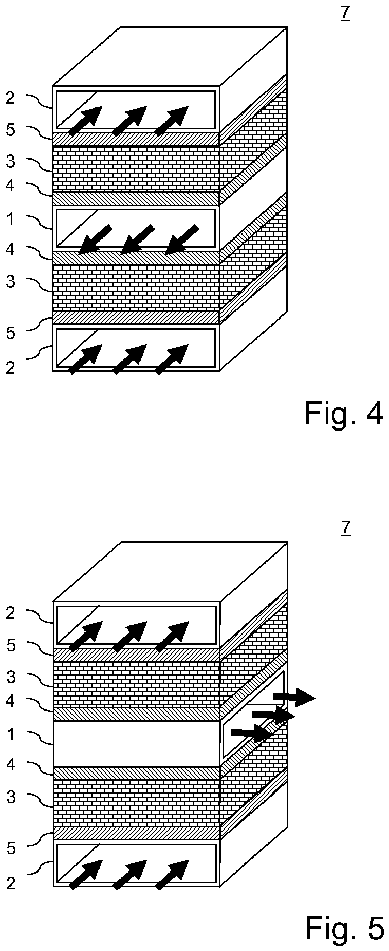

Im Folgenden wird unter Bezugnahme auf die Figur 4 eine vierte Ausführungsform des thermoelektrischen Generators 7 erläutert. Dabei wird nur auf Unterschiede zur ersten Ausführungsform näher eingegangen, und ansonsten auf die Ausführungen zur ersten Ausführungsform verwiesen.

Die in Figur 4 gezeigte vierte Ausführungsform unterscheidet sich von der in den Figuren 1A bis 1C gezeigten ersten Ausführungsform insbesondere dadurch, dass zwei den kalten Luftstrom führende zweite Strömungskanäle 2 vorgesehen sind, zwischen denen der den warmen Abgasstrom führende erste Strömungskanal 1 angeordnet ist. Dabei sind zwischen dem ersten Strömungskanal 1 und den benachbarten zweiten Strömungskanälen 2 jeweils Thermoelemente 3 angeordnet und wird eine Wärmeleitung zwischen dem ersten Strömungskanal 1 und den Thermoelementen 3 jeweils durch eine erste Kontaktschicht 4 hergestellt. Die Wärmeleitung zwischen den Thermoelementen 3 und dem jeweils benachbarten zweiten Strömungskanal 2 wird jeweils über zweite Kontaktelemente 5 hergestellt. Bei dem in Figur 4 gezeigten Aufbau kann die thermische Energie des im ersten Strömungskanal 1 geführten warmen Abgasstroms besonders effektiv genutzt werden.

Im Folgenden wird unter Bezugnahme auf die Figur 5 eine fünfte Ausführungsform des thermoelektrischen Generators 7 erläutert. Dabei wird zur Vermeidung von Wiederholungen nur auf Unterschiede zur vierten Ausführungsform eingegangen und ansonsten auf die vorstehenden Ausführungen verwiesen.

Der in Figur 5 gezeigte thermoelektrische Generator 7 unterscheidet sich von dem in Figur 4 gezeigten thermoelektrischen Generator 7 lediglich dadurch, dass der Generator nicht im Gegenstrom sondern im Kreuzstrom durchströmt wird. Entsprechend sind die zwischen dem ersten Strömungskanal 1 und den beiden zweiten Strömungskanälen 2 jeweils einlagig angeordnete Thermoelemente 3 in mehreren zueinander parallelen Reihen angeordnet.

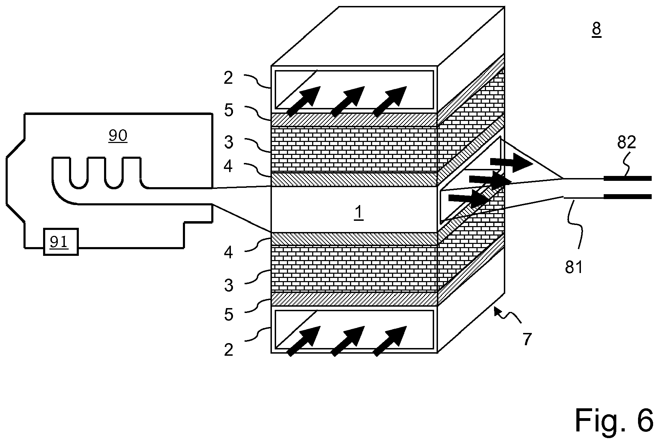

Im Folgenden wird unter Bezugnahme auf die Figur 6 eine Ausführungsform einer Abgasanlage 8 beschrieben, welche den thermoelektrischen Generator 7 gemäß der in Figur 5 gezeigten fünften Ausführungsform verwendet.

Wie aus Figur 6 ersichtlich, wird das von einem eine Motorsteuerung 91 aufweisenden Verbrennungsmotor 90 erzeugte Abgas über den Einlass des ersten Strömungskanal 1 in den thermoelektrischen Generators 7 geführt. Der Auslass des ersten Strömungskanals 1 ist mit einer Abgasleitung 81 der Abgasanlage 8 verbunden, welche Abgasleitung 81 in einem Endrohr 82 mündet.

Natürlich kann die Abgasanlage 8 noch Schalldämpfer oder Abgasreinigungsanlagen oder dergleichen aufweisen; diese Elemente sind der Vereinfachung wegen aber nicht gezeigt.

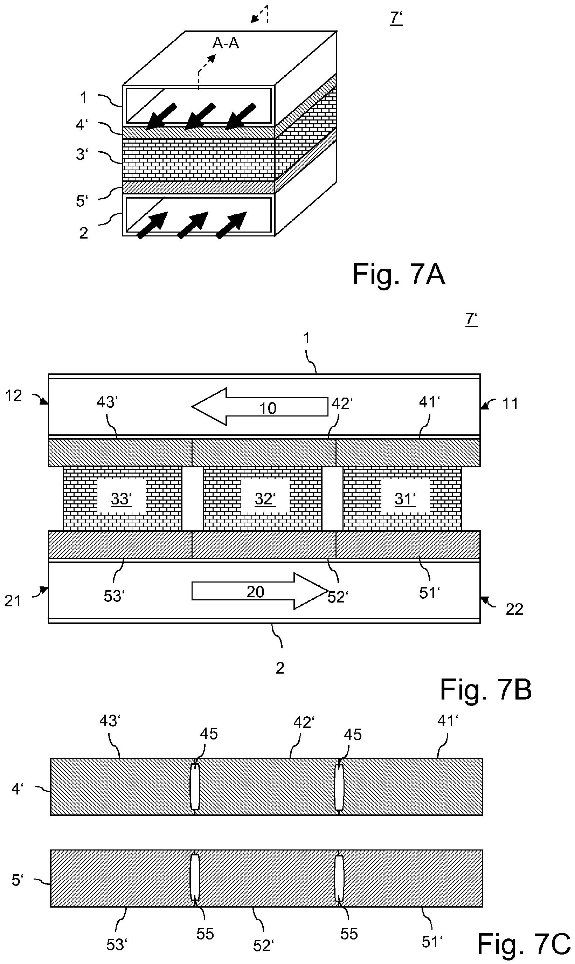

Im Folgenden wird unter Bezugnahme auf die Figuren 7A bis 7C eine sechste Ausführungsform des thermoelektrischen Generators 7' erläutert. Dabei wird zur Vermeidung von Wiederholungen nur auf Unterschiede zur in den Figuren 1A bis 1C beschriebenen ersten Ausführungsform eingegangen und ansonsten auf die vorstehenden Ausführungen verwiesen.

Der thermoelektrische Generator 7' und die zugehörigen Kontaktelemente 4', 5' der sechsten Ausführungsform unterscheidet sich von dem thermoelektrischen Generator 7 und den zugehörigen Kontaktelementen 4, 5 der ersten Ausführungsform dadurch, dass die ersten und zweiten Kontaktelemente 4' und 5' in ihren den Thermoelementen 31', 32' und 33' zugeordneten Kontaktabschnitten 41', 42', 43', 51', 52' und 53' jeweils die gleiche Wärmeleitfähigkeit aufweisen. Entsprechend weisen die ersten und zweiten Kontaktelemente 4' und 5' innerhalb ihrer Kontaktabschnitte 41', 42', 43', 51', 52' und 53' keine Langlöcher oder dergleichen auf. Vielmehr sind nur die Langlöcher 45 und 55 vorgesehen, welche die Kontaktelemente 4' und 5' in die Kontaktabschnitte 41', 42', 43', 51', 52' unterteilen und verhindern, dass es über die Kontaktelemente 4' und 5' zu einer Wärmeleitung zwischen benachbarten Thermoelementen 31', 32' und 33' kommt. Bis auf die Langlöcher 45 und 55 sind die beiden Kontaktelemente 4' und 5' aus einer Wärmeleitfolie aus Kunstglimmer von konstantem Material und Stärke gefertigt.

Dafür sind die Thermoelemente 31', 32' und 33' in dieser Ausführungsform nicht baugleich, sondern jeweils für unterschiedliche Temperaturbereiche ausgebildet. Konkret weist das entlang der ersten Strömungsrichtung 10 am Nächsten zum Einlass 11 des ersten Strömungskanals 1 angeordnete erste Thermoelement 31' bei einer Temperaturdifferenz von 700°C am ersten Strömungskanal 1 zu 200°C am zweiten Strömungskanal 2 den höchsten Wirkungsgrad auf, und das entlang der erste Strömungsrichtung 10 stromabwärts angeordnete zweite Thermoelement 32' weist bei einer Temperaturdifferenz von 650°C am ersten Strömungskanal 1 zu 150°C am zweiten Strömungskanal 2 den höchsten Wirkungsgrad auf.

Somit erfolgt in dieser Ausführungsform die Anpassung an unterschiedliche Temperaturdifferenzen durch entsprechende Wahl der Thermoelemente 3', und wird durch die Langlöcher 45, 55 in den Kontaktelementen 4' und 5' verhindert, dass es über die Kontaktelemente 4' und 5' zu einem Wärmefluss zwischen benachbarten Thermoelementen 3' kommt. Gleichzeitig ist aufgrund der einstückigen Ausbildung der Kontaktelemente 4' und 5' die Montage des thermoelektrischen Generators 7' leicht möglich.

Es wird betont, dass in den vorstehenden Ausführungsformen drauf verzichtet wurde, die elektrische Verschaltung der Thermoelemente und die zugehörige Leistungselektronik darzustellen, da diese für das Verständnis der Funktionsweise der vorliegenden Erfindung nicht erforderlich sind. Aus dem gleichen Grund wurde in Figur 6 darauf verzichtet, die Führung des die zweiten Strömungskanäle 2 beaufschlagenden kalten Luftstroms näher zu erläutern.

Obwohl die voranstehenden Ausführungsbeispiele der vorliegenden Erfindung lediglich beispielhaft erläutert worden sind, werden die Fachleute erkennen, dass zahlreiche Modifikationen, Hinzufügungen und Ersetzungen möglich sind, ohne von dem Schutzbereich und Geist der in den nachfolgenden Ansprüchen offenbarten Erfindung abzuweichen.

So ist der erfindungsgemäße thermoelektrische Generator grundsätzlich geeignet, die in einem beliebigen Fluid enthaltene thermische Energie in elektrische Energie umzuwandeln und somit nicht auf die im Abgas eines verbrennungsmotorisch betriebenen Fahrzeugs enthaltene thermische Energie beschränkt.

## Patentansprüche

1. Thermoelektrischer Generator (7), aufweisend:
einen ersten Strömungskanal (1) mit einem Einlass (11) und einem Auslass (12) zum Führen eines warmen Fluids, wobei der Einlass (11) und der Auslass (12) des ersten Strömungskanals (1) eine erste Strömungsrichtung (10) für das warme Fluid festlegen;
einen zweiten Strömungskanal (2) mit einem Einlass (21) und einem Auslass (22) zum Führen eines kalten Fluids, wobei der Einlass (21) und der Auslass (22) des zweiten Strömungskanals (2) eine zweite Strömungsrichtung (20) für das kalte Fluid festlegen;
eine Mehrzahl von Thermoelementen (3; 31, 32, 33), die in der ersten Strömungsrichtung (10) zueinander benachbart zwischen dem ersten Strömungskanal (1) und dem zweiten Strömungskanal (2) angeordnet sind;
ein zwischen der Mehrzahl von Thermoelementen (3; 31, 32, 33) und einer Wandung des ersten Strömungskanals (1) angeordnetes erstes Kontaktelement (4), welches den einzelnen Thermoelementen (3; 31, 32, 33) zugeordnete Kontaktabschnitte (41, 42, 43) aufweist, die eine wärmeleitende Verbindung zwischen dem jeweils zugehörigen Thermoelement (3; 31, 32, 33) und der Wandung des ersten Strömungskanals (1) bereitstellen; und
ein zwischen der Mehrzahl von Thermoelementen (3; 31, 32, 33) und einer Wandung des zweiten Strömungskanals (2) angeordnetes zweites Kontaktelement (5), welches den einzelnen Thermoelementen (3; 31, 32, 33) zugeordnete Kontaktabschnitte (51, 52, 53) aufweist, die eine wärmeleitende Verbindung zwischen dem jeweils zugehörigen Thermoelement (3; 31, 32, 33) und der Wandung des zweiten Strömungskanals (2) bereitstellen;
**dadurch gekennzeichnet, dass**
die Summe der Wärmedurchgangswiderstände derjenigen Kontaktabschnitte (41, 51) des ersten und zweiten Kontaktelements (4, 5), welche einem ersten Thermoelement (31) zugeordnet sind, das in der ersten Strömungsrichtung (10) stromaufwärts eines zweiten Thermoelements (32) angeordnet ist, größer ist als die Summe der Wärmedurchgangswiderstände derjenigen Kontaktabschnitte (42, 52) des ersten und zweiten Kontaktelements (4, 5), die dem zweiten Thermoelement (32) zugeordnet sind.

2. Thermoelektrischer Generator (7) nach Anspruch 1, wobei die unterschiedlichen Wärmedurchgangswiderstände des ersten Kontaktelements (4) in den Kontaktabschnitten (41, 42, 43) auf einer oder auf mehreren der folgenden Maßnahmen beruhen:
die Dicke des ersten Kontaktelements (4) im Kontaktabschnitt (41) zwischen dem ersten Thermoelement (31) und dem ersten Strömungskanal (1) ist größer als die Dicke des ersten Kontaktelements (4) im Kontaktabschnitt (42) zwischen dem zweiten Thermoelement (32) und dem ersten Strömungskanal (1); und/oder das erste Kontaktelement (4) weist im Kontaktabschnitt (41) zwischen dem ersten Thermoelement (31) und dem ersten Strömungskanal (1) einen niedrigeren Gehalt an Stoffen mit einer hohen Wärmeleitfähigkeit als im Kontaktabschnitt (42) zwischen dem zweiten Thermoelement (32) und dem ersten Strömungskanal (1) auf; und/oder
die effektive Querschnittsfläche des ersten Kontaktelements (4) im Kontaktabschnitt (41) zwischen dem ersten Thermoelement (31) und dem ersten Strömungskanal (1) ist kleiner als die effektive Querschnittsfläche des ersten Kontaktelements (4) im Kontaktabschnitt (42) zwischen dem zweiten Thermoelement (32) und dem ersten Strömungskanal (1); und/oder die Größe der mit dem ersten Thermoelement (31) im Kontaktabschnitt (41) des ersten Kontaktelements (4) in Kontakt befindlichen Oberfläche ist kleiner als die Größe der mit dem zweiten Thermoelement (32) im Kontaktabschnitt (42) des ersten Kontaktelements (4) in Kontakt befindlichen Oberfläche.

3. Thermoelektrischer Generator (7) nach Anspruch 1 oder 2, wobei die unterschiedlichen Wärmedurchgangswiderstände des zweiten Kontaktelements (5) in den Kontaktabschnitten (51, 52, 53) auf einer oder auf mehreren der folgenden Maßnahmen beruhen:
die Dicke des zweiten Kontaktelements (5) im Kontaktabschnitt (51) zwischen dem ersten Thermoelement (31) und dem zweiten Strömungskanal (2) ist verschieden von der Dicke des zweiten Kontaktelements (5) im Kontaktabschnitt (52) zwischen dem zweiten Thermoelement (32) und dem zweiten Strömungskanal (2); und/oder
das zweiten Kontaktelement (5) weist im Kontaktabschnitt (51) zwischen dem ersten Thermoelement (31) und dem zweiten Strömungskanal (2) einen unterschiedlichen Gehalt an Stoffen mit einer hohen Wärmeleitfähigkeit als im Kontaktabschnitt (52) zwischen dem zweiten Thermoelement (32) und dem zweiten Strömungskanal (2) auf; und/oder
die effektive Querschnittsfläche des zweiten Kontaktelements (5) im Kontaktabschnitt (51) zwischen dem ersten Thermoelement (31) und dem zweiten Strömungskanal (2) ist verschieden von der effektiven Querschnittsfläche des zweiten Kontaktelements (5) im Kontaktabschnitt (52) zwischen dem zweiten Thermoelement (32) und dem zweiten Strömungskanal (2); und/oder
die Größe der mit dem ersten Thermoelement (31) im Kontaktabschnitt (51) des zweiten Kontaktelements (5) in Kontakt befindlichen Oberfläche ist verschieden von der Größe der mit dem zweiten Thermoelement (32) im Kontaktabschnitt (52) des zweiten Kontaktelements (5) in Kontakt befindlichen Oberfläche.

4. Thermoelektrischer Generator (7) nach Anspruch 1, 2 oder 3,
wobei wenigstens eines von dem ersten und zweiten Kontaktelement (4, 5) zwischen demjenigen Kontaktabschnitt (41, 51), welcher dem ersten Thermoelement (31) zugeordnet ist, und demjenigen Kontaktabschnitt (42, 52), welcher dem zweiten Thermoelement (32) zugeordnet ist, einen Trennungsbereich (45, 55) aufweist, in welchem der Wärmedurchgangswiderstand gegenüber dem mittleren Wärmedurchgangswiderstand der benachbarten Kontaktabschnitte (41, 42; 51, 52) um wenigstens das Fünffache erhöht ist; oder
wobei wenigstens eines von dem ersten und zweiten Kontaktelement (4, 5) zwischen demjenigen Kontaktabschnitt (41, 51), welcher dem ersten Thermoelement (31) zugeordnet ist, und demjenigen Kontaktabschnitt (42, 52), welcher dem zweiten Thermoelement (32) zugeordnet ist, einen Trennungsbereich (45, 55) aufweist, in welchem der Wärmedurchgangswiderstand gegenüber dem mittleren Wärmedurchgangswiderstand der benachbarten Kontaktabschnitte (41, 42; 51, 52) um wenigstens das Zehnfache erhöht ist.

5. Thermoelektrischer Generator (7) nach einem der Ansprüche 1 bis 4, wobei das erste Kontaktelement (4) in wenigstens einem Kontaktabschnitt (41, 42) wenigstens eine Aussparung (46) aufweist, deren größte Ausdehnung in die erste Strömungsrichtung (10) orientiert ist; und/oder
wobei das zweite Kontaktelement (5) in wenigstens einem Kontaktabschnitt (51, 52) wenigstens eine Aussparung (56) aufweist, deren größte Ausdehnung in die zweite Strömungsrichtung (20) orientiert ist.

6. Thermoelektrischer Generator (7) nach einem der Ansprüche 1 bis 5,
wobei das erste Kontaktelement (4) zwischen demjenigen Kontaktabschnitt (41), welcher dem ersten Thermoelement (31) zugeordnet ist, und demjenigen Kontaktabschnitt (42), welcher dem zweiten Thermoelement (32) zugeordnet ist, wenigstens eine Aussparung (45) aufweist, deren größte Ausdehnung quer zur ersten Strömungsrichtung (10) orientiert ist; und/oder
wobei das zweite Kontaktelement (5) zwischen demjenigen Kontaktabschnitt (51), welcher dem ersten Thermoelement (31) zugeordnet ist, und demjenigen Kontaktabschnitt (52), welcher dem zweiten Thermoelement (32) zugeordnet ist, wenigstens eine Aussparung (55) aufweist, deren größte Ausdehnung quer zur zweiten Strömungsrichtung (20) orientiert ist.

7. Thermoelektrischer Generator (7) nach einem der Ansprüche 1 bis 6, wobei der Wärmedurchgangswiderstand des ersten Kontaktelements (4) in demjenigen Kontaktabschnitt (41), welcher dem ersten Thermoelement (31) zugeordnet ist, größer ist als der Wärmedurchgangswiderstand des ersten Kontaktelements (4) in demjenigen Kontaktabschnitt (42), welcher dem zweiten Thermoelement (32) zugeordnet ist.

8. Thermoelektrischer Generator (7) nach einem der Ansprüche 1 bis 7,
wobei der Wärmedurchgangswiderstand des zweiten Kontaktelements (5) in demjenigen Kontaktabschnitt (51), welcher dem ersten Thermoelement (31) zugeordnet ist, größer ist als der Wärmedurchgangswiderstand des zweiten Kontaktelements (5) in demjenigen Kontaktabschnitt (52), welcher dem zweiten Thermoelement (32) zugeordnet ist, wenn die erste Strömungsrichtung (10) und die zweite Strömungsrichtung (20) gleich orientiert sind, und
wobei der Wärmedurchgangswiderstand des zweiten Kontaktelements (5) in demjenigen Kontaktabschnitt (51), welcher dem ersten Thermoelement (31) zugeordnet ist, niedriger ist als der Wärmedurchgangswiderstand des zweiten Kontaktelements (5) in demjenigen Kontaktabschnitt (52), welcher dem zweiten Thermoelement (32) zugeordnet ist, wenn die erste Strömungsrichtung (10) und die zweite Strömungsrichtung (20) entgegengesetzt orientiert sind.

9. Thermoelektrischer Generator (7) nach einem der Ansprüche 1 bis 8,
wobei die Wandung des ersten Strömungskanals (1), an welcher das erste Kontaktelement (4) angeordnet ist, glatt und frei von Kühlrippen ist; oder wobei die Wandung des ersten Strömungskanals (1), an welcher das erste Kontaktelement (4) angeordnet ist, Kühlrippen (61) aufweist, die entlang der ersten Strömungsrichtung (10) gleichmäßig verteilt angeordnet sind; und/oder wobei die Wandung des zweiten Strömungskanals (2), an welcher das zweite Kontaktelement (5) angeordnet ist, glatt und frei von Kühlrippen ist; oder wobei die Wandung des zweiten Strömungskanals (2), an welcher das zweite Kontaktelement (5) angeordnet ist, Kühlrippen (62) aufweist, die entlang der zweiten Strömungsrichtung (20) gleichmäßig verteilt angeordnet sind.

10. Thermoelektrischer Generator (7) nach einem der Ansprüche 1 bis 9, wobei das erste Kontaktelement (4) alle Kontaktabschnitte (41, 42, 43) einstückig bereitstellt; und/oder
wobei das zweite Kontaktelement (5) alle Kontaktabschnitte (51, 52, 53) einstückig bereitstellt; und/oder
wobei die Mehrzahl von Thermoelementen (3; 31, 32, 33) einlagig zwischen dem ersten Strömungskanal (1) und dem zweiten Strömungskanal (2) angeordnet sind; und/oder
wobei das erste Thermoelement (31) und das zweite Thermoelement (32) untereinander baugleich sind oder wobei alle Thermoelemente (3; 31, 32, 33) der Mehrzahl von Thermoelementen (3; 31, 32, 33) untereinander baugleich sind; und/oder
wobei das erste Kontaktelement (4) eine Wärmeleitfolie aus Graphit oder Silikonkautschuk oder Polyimid oder Aluminiumoxid oder Kunstglimmer oder Acrylpolymer ist; und/oder
wobei das zweite Kontaktelement (5) eine Wärmeleitfolie aus Graphit oder Silikonkautschuk oder Polyimid oder Aluminiumoxid oder Kunstglimmer oder Acrylpolymer ist.

11. Thermoelektrischer Generator (7), aufweisend:
einen Strömungskanal (1, 2) mit einem Einlass (11, 21) und einem Auslass (12, 22) zum Führen eines Fluids, wobei der Einlass (11, 21) und der Auslass (12, 22) des Strömungskanals (1, 2) eine Strömungsrichtung (10, 20) für das Fluid festlegen;
eine Mehrzahl von Thermoelementen (3'; 31', 32', 33'), die in der Strömungsrichtung (10, 20) zueinander benachbart neben dem Strömungskanal (1, 2) angeordnet sind; und
ein zwischen der Mehrzahl von Thermoelementen (3'; 31', 32', 33') und einer Wandung des Strömungskanals (1, 2) angeordnetes Kontaktelement (4', 5'), welches den einzelnen Thermoelementen (3'; 31', 32', 33') zugeordnete Kontaktabschnitte (41', 42', 43') aufweist, die eine wärmeleitende Verbindung zwischen dem jeweils zugehörigen Thermoelement (3'; 31', 32', 33') und der Wandung des Strömungskanals (1, 2) bereitstellen;
**dadurch gekennzeichnet, dass**
das Kontaktelement (4', 5') zwischen benachbarten Kontaktabschnitten (41', 42'; 42', 43'; 51', 52'; 52', 53'), welche einander benachbarten Thermoelementen (31', 32'; 32', 33') zugeordnet sind, einen Trennungsbereich (45, 55) aufweist, in welchem der Wärmedurchgangswiderstand gegenüber dem mittleren Wärmedurchgangswiderstand der benachbarten Kontaktabschnitte (41', 42'; 42', 43'; 51', 52'; 52', 53') um wenigstens das Fünffache erhöht ist; oder
das Kontaktelement (4', 5') zwischen benachbarten Kontaktabschnitten (41', 42'; 42', 43'; 51', 52'; 52', 53'), welche einander benachbarten Thermoelementen (31', 32'; 32', 33') zugeordnet sind, einen Trennungsbereich (45, 55) aufweist, in welchem der Wärmedurchgangswiderstand gegenüber dem mittleren Wärmedurchgangswiderstand der benachbarten Kontaktabschnitte (41, 42; 51, 52) um wenigstens das Zehnfache erhöht ist.

12. Thermoelektrischer Generator (7) nach Anspruch 11,
wobei einander benachbarte Thermoelemente (31', 32'; 32', 33') für unterschiedliche Temperaturbereiche ausgelegt sind; und/oder wobei das Kontaktelement (4', 5') zwischen benachbarten Kontaktabschnitten (41', 42'; 42', 43'; 51', 52'; 52', 53'), welche einander benachbarten Thermoelementen (31', 32'; 32', 33') zugeordnet sind, wenigstens eine Aussparung (45, 55) aufweist, deren größte Ausdehnung quer zur Strömungsrichtung (10, 20) orientiert ist.

13. Abgasanlage (8) für ein verbrennungsmotorisch betriebenes Fahrzeug, aufweisend einen thermoelektrischen Generator (7) nach einem der Ansprüche 1 bis 12, wobei der erste Strömungskanal (1) eine Abgasleitung der Abgasanlage ist oder mit einer Abgasleitung (81) der Abgasanlage verbindbar ist.

14. Kontaktelement (4', 5') für einen thermoelektrischen Generator (7), insbesondere für einen thermoelektrischen Generator (7) nach einem der Ansprüche 11 oder 12,
wobei das Kontaktelement (4', 5') eine Mehrzahl von Kontaktabschnitten (41', 42', 43', 51', 52', 53') aufweist, die ausgebildet sind, eine wärmeleitende Verbindung zwischen einem jeweils zugehörigen Thermoelement (3'; 31', 32', 33') eines thermoelektrischen Generator (7) und einer Wandung eines Strömungskanals (1, 2) bereitzustellen;
**dadurch gekennzeichnet, dass**
das Kontaktelement (4', 5') zwischen benachbarten Kontaktabschnitten (41', 42'; 42', 43'; 51', 52'; 52', 53'), welche einander benachbarten Thermoelementen (31', 32'; 32', 33') zugeordnet sind, einen Trennungsbereich (45, 55) aufweist, in welchem der Wärmedurchgangswiderstand gegenüber dem mittleren Wärmedurchgangswiderstand der benachbarten Kontaktabschnitte (41', 42'; 42', 43'; 51', 52'; 52', 53') um wenigstens das Fünffache erhöht ist; und/oder das Kontaktelement (4', 5') zwischen benachbarten Kontaktabschnitten (41', 42'; 42', 43'; 51', 52'; 52', 53'), welche einander benachbarten Thermoelementen (31', 32'; 32', 33') zugeordnet sind, eine Aussparung (45, 55) aufweist, deren größte Ausdehnung in Richtung einer Trennungslinie zwischen benachbarten Kontaktabschnitten (41', 42'; 42', 43'; 51', 52'; 52', 53') orientiert ist.

15. Kontaktelement (4', 5') nach Anspruch 14,
wobei das Kontaktelement (4', 5') die Form eines Rechtecks mit zwei parallelen langen Seiten und zwei parallelen kurzen Seiten aufweist, und zwischen benachbarten Kontaktabschnitten (41', 42'; 42', 43'; 51', 52'; 52', 53'), welche einander benachbarten Thermoelementen (31', 32'; 32', 33') zugeordnet sind, eine Aussparung (45, 55) vorgesehen ist, deren größte Ausdehnung parallel zu den kurzen Seiten des Kontaktelements (4', 5') orientiert ist; und/oder wobei das Kontaktelement (4', 5') alle Kontaktabschnitte (41', 42', 43', 51', 52', 53') einstückig bereitstellt; und/oder
durch eine Wärmeleitfolie aus Graphit oder Silikonkautschuk oder Polyimid oder Aluminiumoxid oder Kunstglimmer oder Acrylpolymer gebildet ist.

## Claims

1. A thermoelectric generator (7), comprising:
a first flow channel (1) having an inlet (11) and an outlet (12) for passing a warm fluid, the inlet (11) and the outlet (12) of the first flow channel (1) defining a first direction of flow (10) for the warm fluid;
a second flow channel (2) having an inlet (21) and an outlet (22) for passing a cold fluid, the inlet (21) and the outlet (22) of the second flow channel (2) defining a second direction of flow (20) for the cold fluid;
a plurality of thermocouple elements (3; 31, 32, 33) disposed between the first flow channel (1) and the second flow channel (2) and neighboring each other along the first direction of flow (10);
a first contact member (4) disposed between the plurality of thermocouple elements (3; 31, 32, 33) and a wall of the first flow channel (1), the first contact member (4) comprising contact portions (41, 42, 43) associated with the individual thermocouple elements (3; 31, 32, 33), the contact portions (41, 42, 43) providing a heat conducting coupling between the respectively associated thermocouple elements (3; 31, 32, 33) and the wall of the first flow channel (1); and
a second contact member (5) disposed between the plurality of thermocouple elements (3; 31, 32, 33) and a wall of the second flow channel (2), the second contact member (5) comprising contact portions (51, 52, 53) associated with the individual thermocouple elements (3; 31, 32, 33), the contact portions (51, 52, 53) providing a heat conducting coupling between the respectively associated thermocouple elements (3; 31, 32, 33) and the wall of the second flow channel (2);
**characterized in, that**
the sum of the thermal resistances of those contact portions (41, 51) of the first and second contact members (4, 5) that are associated with a first thermocouple element (31) positioned along the first direction of flow (10) upstream of a second thermocouple element (32), is bigger than the sum of the thermal resistances of those contact portions (42, 52) of the first and second contact members (4, 5) that are associated with the second thermocouple element (32).

2. The thermoelectric generator (7) according to claim 1, wherein the different thermal resistances of the first contact member (4) at the contact portions (41, 42, 43) are based on one or more of the following measures:
the thickness of the first contact member (4) is in the contact portion (41) between the first thermocouple element (31) and the first flow channel (1) bigger than the thickness of the first contact member (4) in the contact portion (42) between the second thermocouple element (32) and the first flow channel (1); and/or
the content of substances having a high thermal conductivity of the first contact member (4) is lower in the contact portion (41) between the first thermocouple element (31) and the first flow channel (1) than in the contact portion (42) between the second thermocouple element (32) and the first flow channel (1); and/or
the effective cross-sectional area of the first contact member (4) at the contact portion (41) between the first thermocouple element (31) and the first flow channel (1) is smaller than the effective cross-sectional area of the first contact member (4) at the contact portion (42) between the second thermocouple element (32) and the first flow channel (1); and/or
the size of the surface contacting the first thermocouple element (31) at the contact portion (41) of the first contact member (4) is smaller than the size of the surface contacting the second thermocouple element (32) at the contact portion (42) of the first contact member (4).

3. The thermoelectric generator (7) according to claim 1 or 2, wherein the different thermal resistances of the second contact member (5) at the contact portions (51, 52, 53) are based on one or more of the following measures:
the thickness of the second contact member (5) is in the contact portion (51) between the first thermocouple element (31) and the second flow channel (2) different to the thickness of the second contact member (5) in the contact portion (52) between the second thermocouple element (32) and the second flow channel (2); and/or
the content of substances having a high thermal conductivity of the second contact member (5) is in the contact portion (51) between the first thermocouple element (31) and the second flow channel (2) different to that in the contact portion (52) between the second thermocouple element (32) and the second flow channel (2); and/or
the effective cross-sectional area of the second contact member (5) at the contact portion (51) between the first thermocouple element (31) and the second flow channel (2) is different to the effective cross-sectional area of the second contact member (5) at the contact portion (52) between the second thermocouple element (32) and the second flow channel (2); and/or
the size of the surface contacting the first thermocouple element (31) at the contact portion (51) of the second contact member (5) is different to the size of the surface contacting the second thermocouple element (32) at the contact portion (52) of the second contact member (5).

4. The thermoelectric generator (7) according to claim 1, 2 or 3,
wherein at least one of the first and second contact member (4, 5) between the contact portion (41, 51) associated with the first thermocouple element (31) and the contact portion (42, 52) associated with the second thermocouple element (32) comprises an isolation region (45, 55), where the thermal resistance is increased with respect to the average thermal resistance of the neighboring contact portions (41, 42; 51, 52) by at least five times; or
wherein at least one of the first and second contact member (4, 5) between the contact portion (41, 51) associated with the first thermocouple element (31) and the contact portion (42, 52) associated with the second thermocouple element (32) comprises an isolation region (45, 55), where the thermal resistance is increased with respect to the average thermal resistance of the neighboring contact portions (41, 42; 51, 52) by at least ten times.

5. The thermoelectric generator (7) according to one of claims 1 to 4,
wherein the first contact member (4) comprises at least one recess (46) in at least one contact portion (41, 42), with the largest dimension of the recess (46) being oriented in the first direction of flow (10); and/or
wherein the second contact member (5) comprises at least one recess (56) in at least one contact portion (51, 52), with the largest dimension of the recess (56) being oriented in the second direction of flow (20).

6. The thermoelectric generator (7) according to one of claims 1 to 5,
wherein the first contact member (4) comprises between the contact portion (41) associated with the first thermocouple element (31) and the contact portion (42) associated with the second thermocouple element (32) at least one recess (45) having its largest dimension oriented transverse to the first direction of flow (10); and/or
wherein the second contact member (5) comprises between the contact portion (51) associated with the first thermocouple element (31) and the contact portion (52) associated with the second thermocouple element (32) at least one recess (55) having its largest dimension oriented transverse to the second direction of flow (20).

7. The thermoelectric generator (7) according to one of claims 1 to 6, wherein the thermal resistance of the first contact member (4) is higher in the contact portion (41) associated with the first thermocouple element (31) than the thermal resistance of the first contact member (4) in the contact portion (42) associated with the second thermocouple element (32).

8. The thermoelectric generator (7) according to one of claims 1 to 7, wherein, when the first direction of flow (10) and the second direction of flow (20) have the same orientation, the thermal resistance of the second contact member (5) is higher in the contact portion (51) associated with the first thermocouple element (31) than the thermal resistance of the second contact member (5) in the contact portion (52) associated with the second thermocouple element (32), and wherein, when the first direction of flow (10) and the second direction of flow (20) have opposite orientations, the thermal resistance of the second contact member (5) is lower in the contact portion (51) associated with the first thermocouple element (31) than the thermal resistance of the second contact member (5) in the contact portion (52) associated with the second thermocouple element (32).

9. The thermoelectric generator (7) according to one of claims 1 to 8,
wherein the wall of the first flow channel (1) on which the first contact member (4) is disposed is smooth and has no cooling fins; or
wherein the wall of the first flow channel (1) on which the first contact member (4) is disposed has cooling fins (61) evenly distributed along the first direction of flow (10); and/or
wherein the wall of the second flow channel (2) on which the second contact member (5) is disposed is smooth and has no cooling fins; or
wherein the wall of the second flow channel (2) on which the second contact member (5) is disposed has cooling fins (62) evenly distributed along the second direction of flow (20).

10. The thermoelectric generator (7) according to one of claims 1 to 9,
wherein the first contact member (4) provides all contact portions (41, 42, 43) in a monobloc design; and/or
wherein the second contact member (5) provides all contact portions (51, 52, 53) in a monobloc design; and/or
wherein the plurality of thermocouple elements (31, 32, 33) is disposed as a single layer between the first flow channel (1) and the second flow channel (2); and/or wherein the first thermocouple element (31) and the second thermocouple element (32) are identical in construction or wherein all thermocouple elements (3; 31, 32, 33) of the plurality of thermocouple elements (3; 31, 32, 33) are identical in construction; and/or
wherein the first contact member (4) is a heat conducting film made of graphite or silicone rubber or polyimide or alumina or micanite or acrylic polymer; and/or
wherein the second contact member (5) is a heat conducting film made of graphite or silicone rubber or polyimide or alumina or micanite or acrylic polymer.

11. A thermoelectric generator (7), comprising:
a flow channel (1, 2) having an inlet (11, 21) and an outlet (12, 22) for passing a fluid, the inlet (11, 21) and the outlet (12, 22) of the flow channel (1, 2) defining a direction of flow (10, 20) for the fluid;
a plurality of thermocouple elements (3'; 31', 32', 33') disposed next to the flow channel (1, 2) and neighboring each other along the direction of flow (10, 20); and
a contact member (4', 5') disposed between the plurality of thermocouple elements (3'; 31', 32', 33') and a wall of the flow channel (1, 2), the contact member comprising contact portions (41', 42', 43') associated with the individual thermocouple elements (3'; 31', 32', 33'), the contact portions (41', 42', 43') providing a heat conducting coupling between the respectively associated thermocouple elements (3'; 31', 32', 33') and the wall of the flow channel (1, 2);
**characterized in, that**
the contact member (4', 5') comprises an isolation region (45, 55) between neighboring contact portions (41', 42'; 42', 43'; 51', 52'; 52', 53') associated with thermocouple elements (3'; 31', 32', 33') neighboring each other, the thermal resistance of the isolation region (45, 55) being increased with respect to the average thermal resistance of the neighboring contact portions (41', 42'; 42', 43'; 51', 52'; 52', 53') by at least five times; or
the contact member (4', 5') comprises an isolation region (45, 55) between neighboring contact portions (41', 42'; 42', 43'; 51', 52'; 52', 53') associated with thermocouple elements (3'; 31', 32', 33') neighboring each other, the thermal resistance of the isolation region (45, 55) being increased with respect to the average thermal resistance of the neighboring contact portions (41, 42; 51, 52) by at least ten times.

12. The thermoelectric generator (7) according to claim 11,
wherein thermocouple elements (3'; 31', 32', 33') neighboring each other are configured for different temperature ranges; and/or
wherein the contact member (4', 5') comprises between neighboring contact portions (41', 42'; 42', 43'; 51', 52'; 52', 53') associated with thermocouple elements (3'; 31', 32', 33') neighboring each other at least one recess (45, 55) with its largest dimension oriented transverse to the flow direction (10, 20).

13. An exhaust system (8) for a vehicle driven by an internal combustion engine, comprising a thermoelectric generator (7) according to one of claims 1 to 12, the first flow channel (1) being an exhaust gas line of the exhaust system or configured for being coupled with an exhaust gas line (81) of the exhaust system.

14. A contact member (4', 5') for a thermoelectric generator (7), in particular for a thermoelectric generator (7) according to one of claims 11 or 12,
wherein the contact member (4', 5') comprises a plurality of contact portions (41', 42', 43', 51', 52', 53') configured to provide a heat conducting coupling between a respective associated thermocouple element (3', 31', 32', 33') of a thermoelectric generator (7) and a wall of a flow channel (1, 2);
**characterized in, that**
the contact member (4', 5') comprises an isolation region (45, 55) between neighboring contact portions (41', 42'; 42', 43'; 51', 52'; 52', 53') associated with thermocouple elements (3'; 31', 32', 33') neighboring each other, the thermal resistance of the isolation region (45, 55) being increased with respect to the average thermal resistance of the neighboring contact portions (41', 42'; 42', 43'; 51', 52'; 52', 53') by at least five times; and/or
the contact member (4', 5') comprises a recess (45, 55) between neighboring contact portions (41', 42'; 42', 43'; 51', 52'; 52', 53') associated with thermocouple elements (3'; 31', 32', 33') neighboring each other, the largest dimension of the recess (45, 55) being oriented in the direction of a separation line between neighboring contact portions (41', 42'; 42', 43'; 51', 52'; 52', 53').

15. The contact member (4', 5') according to claim 14,
wherein the contact member (4', 5') has the shape of a rectangle with two long sides in parallel and two short sides in parallel, and wherein a recess (45, 55) is provided between neighboring contact portions (41', 42'; 42', 43'; 51', 52'; 52', 53') associated with thermocouple elements (3'; 31', 32', 33') neighboring each other, the largest dimension of the recess (45, 55) being oriented in parallel to the short sides of the contact member (4', 5'); and/or
wherein the contact member (4', 5') provides all contact portions (41', 42', 43', 51', 52', 53') in a monobloc design; and/or
wherein the contact member (4', 5') is formed by a heat conducting film made of graphite or silicone rubber or polyimide or alumina or micanite or acrylic polymer.

## Revendications

1. Générateur thermoélectrique (7), présentant :
un premier canal d'écoulement (1) avec une entrée (11) et une sortie (12) pour le guidage d'un fluide chaud, dans lequel l'entrée (11) et la sortie (12) du premier canal d'écoulement (1) définissent un premier sens d'écoulement (10) pour le fluide chaud ;
un deuxième canal d'écoulement (2) avec une entrée (21) et une sortie (22) pour le guidage d'un fluide froid, dans lequel l'entrée (21) et la sortie (22) du deuxième canal d'écoulement (2) définissent un deuxième sens d'écoulement (20) pour le fluide froid ;
une pluralité de thermocouples (3 ; 31, 32, 33), qui sont agencés de manière adjacente l'un à l'autre dans le premier sens d'écoulement (10) entre le premier canal d'écoulement (1) et le deuxième canal d'écoulement (2) ;
un premier élément de contact (4) agencé entre la pluralité de thermocouples (3 ; 31, 32, 33) et une paroi du premier canal d'écoulement (1), qui présente des sections de contact (41, 42, 43) attribuées aux différents thermocouples (3 ; 31, 32, 33), qui mettent à disposition une liaison conductrice de chaleur entre le thermocouple (3 ; 31, 32, 33) respectivement associé et la paroi du premier canal d'écoulement (1) ; et
un deuxième élément de contact (5) agencé entre la pluralité de thermocouples (3 ; 31, 32, 33) et une paroi du deuxième canal d'écoulement (2),
qui présente des sections de contact (51, 52, 53) attribuées aux différents thermocouples (3 ; 31, 32, 33), qui mettent à disposition une liaison conductrice de chaleur entre le thermocouple (3 ; 31, 32, 33) respectivement associé et la paroi du deuxième canal d'écoulement (2) ;
**caractérisé en ce que**
la somme des résistances thermiques des sections de contact (41, 51) des premier et deuxième éléments de contact (4, 5), qui sont attribuées à un premier thermocouple (31), qui est agencé dans le premier sens d'écoulement (10) en amont d'un deuxième thermocouple (32), est supérieure à la somme des résistances thermiques des sections de contact (42, 52) des premier et deuxième éléments de contact (4, 5), qui sont attribuées au deuxième thermocouple (32).

2. Générateur thermoélectrique (7) selon la revendication 1, dans lequel les différentes résistances thermiques du premier élément de contact (4) dans les sections de contact (41, 42, 43) reposent sur une ou sur plusieurs des mesures suivantes :
l'épaisseur du premier élément de contact (4) dans la section de contact (41) entre le premier thermocouple (31) et le premier canal d'écoulement (1) est supérieure à l'épaisseur du premier élément de contact (4) dans la section de contact (42) entre le deuxième thermocouple (32) et le premier canal d'écoulement (1) ; et/ou le premier élément de contact (4) présente dans la section de contact (41) entre le premier thermocouple (31) et le premier canal d'écoulement (1), une teneur en substance à conductibilité thermique élevée inférieure à celle dans la section de contact (42) entre le deuxième thermocouple (32) et le premier canal d'écoulement (1) ; et/ou
la section transversale effective du premier élément de contact (4) dans la section de contact (41) entre le premier thermocouple (31) et le premier canal d'écoulement (1) est inférieure à la section transversale effective du premier élément de contact (4) dans la section de contact (42) entre le deuxième thermocouple (32) et le premier canal d'écoulement (1) ; et/ou la taille de la surface se trouvant en contact avec le premier thermocouple (31) dans la section de contact (41) du premier élément de contact (4) est inférieure à la taille de la surface se trouvant en contact avec le deuxième thermocouple (32) dans la section de contact (42) du premier élément de contact (4).

3. Générateur thermoélectrique (7) selon la revendication 1 ou 2, dans lequel les différentes résistances thermiques du deuxième élément de contact (5) dans les sections de contact (51, 52, 53) reposent sur une ou sur plusieurs des mesures suivantes :
l'épaisseur du deuxième élément de contact (5) dans la section de contact (51) entre le premier thermocouple (31) et le deuxième canal d'écoulement (2) est différente de l'épaisseur du deuxième élément de contact (5) dans la section de contact (52) entre le deuxième thermocouple (32) et le deuxième canal d'écoulement (2) ; et/ou
le deuxième élément de contact (5) présente dans la section de contact (51) entre le premier thermocouple (31) et le deuxième canal d'écoulement (2) une teneur en substance à conductibilité thermique élevée différente de celle dans la section de contact (52) entre le deuxième thermocouple (32) et le deuxième canal d'écoulement (2) ; et/ou
la section transversale effective du deuxième élément de contact (5) dans la section de contact (51) entre le premier thermocouple (31) et le deuxième canal d'écoulement (2) est différente de la section transversale effective du deuxième élément de contact (5) dans la section de contact (52) entre le deuxième thermocouple (32) et le deuxième canal d'écoulement (2) ; et/ou la taille de la surface se trouvant en contact avec le premier thermocouple (31) dans la section de contact (51) du deuxième élément de contact (5) est différente de la taille de la surface se trouvant en contact avec le deuxième thermocouple (32) dans la section de contact (52) du deuxième élément de contact (5).

4. Générateur thermoélectrique (7) selon la revendication 1, 2 ou 3,
dans lequel au moins un des premier et deuxième éléments de contact (4, 5) entre la section de contact (41, 51), celle celle qui est attribuée au premier thermocouple (31), et la section de contact (42, 52), celle qui est attribuée au deuxième thermocouple (32), présente une zone de séparation (45, 55), dans laquelle la résistance thermique est au moins cinq fois supérieure à la résistance thermique moyenne des sections de contact (41, 42 ; 51, 52) adjacentes ; ou dans lequel au moins un des premier et deuxième éléments de contact (4, 5) entre la section de contact (41, 51), celle qui est attribuée au premier thermocouple (31), et la section de contact (42, 52), celle qui est attribuée au deuxième thermocouple (32), présente une zone de séparation (45, 55), dans laquelle la résistance thermique est au moins dix fois supérieure à la résistance thermique moyenne des sections de contact (41, 42 ; 51, 52) adjacentes.

5. Générateur thermoélectrique (7) selon l'une des revendications 1 à 4,
dans lequel le premier élément de contact (4) présente dans au moins une section de contact (41, 42) au moins un évidement (46), dont la plus grande dimension est orientée dans le premier sens d'écoulement (10) ; et/ou dans lequel le deuxième élément de contact (5) présente dans au moins une section de contact (51, 52) au moins un évidement (56), dont la plus grande dimension est orientée dans le deuxième sens d'écoulement (20).

6. Générateur thermoélectrique (7) selon l'une des revendications 1 à 5, dans lequel le premier élément de contact (4) entre la section de contact (41), celle qui est attribuée au premier thermocouple (31), et la section de contact (42), celle qui est attribuée au deuxième thermocouple (32), présente au moins un évidement (45), dont la plus grande dimension est orientée transversalement au premier sens d'écoulement (10) ; et/ou
dans lequel le deuxième élément de contact (5) entre la section de contact (51), celle qui est attribuée au premier thermocouple (31), et la section de contact (52), celle qui est attribuée au deuxième thermocouple (32), présente au moins un évidement (55), dont la plus grande dimension est orientée transversalement au deuxième sens d'écoulement (20).

7. Générateur thermoélectrique (7) selon l'une des revendications 1 à 6, dans lequel la résistance thermique du premier élément de contact (4) dans la section de contact (41), celle qui est attribuée au premier thermocouple (31), est supérieure à la résistance thermique du premier élément de contact (4) dans la section de contact (42), celle qui est attribuée au deuxième thermocouple (32).

8. Générateur thermoélectrique (7) selon l'une des revendications 1 à 7,
dans lequel la résistance thermique du deuxième élément de contact (5) dans la section de contact (51), celle qui est attribuée au premier thermocouple (31), est supérieure à la résistance thermique du deuxième élément de contact (5) dans la section de contact (52), celle qui est attribuée au deuxième thermocouple (32), lorsque le premier sens d'écoulement (10) et le deuxième sens d'écoulement (20) sont orientés dans le même sens, et
dans lequel la résistance thermique du deuxième élément de contact (5) dans la section de contact (51), celle qui est attribuée au premier thermocouple (31), est inférieure à la résistance thermique du deuxième élément de contact (5) dans la section de contact (52), celle qui est attribuée au deuxième thermocouple (32), lorsque le premier sens d'écoulement (10) et le deuxième sens d'écoulement (20) sont orientés de manière opposée.

9. Générateur thermoélectrique (7) selon l'une des revendications 1 à 8,
dans lequel la paroi du premier canal d'écoulement (1), au niveau de laquelle le premier élément de contact (4) est agencé, est lisse et dépourvue de nervures de refroidissement ; ou
dans lequel la paroi du premier canal d'écoulement (1), au niveau de laquelle le premier élément de contact (4) est agencé, présente des nervures de refroidissement (61), qui sont agencées uniformément réparties le long du premier sens d'écoulement (10) ; et/ou
dans lequel la paroi du deuxième canal d'écoulement (2), au niveau de laquelle le deuxième élément de contact (5) est agencé, est lisse et dépourvue de nervures de refroidissement ; ou
dans lequel la paroi du deuxième canal d'écoulement (2), au niveau de laquelle le deuxième élément de contact (5) est agencé, présente des nervures de refroidissement (62), qui sont agencées uniformément réparties le long du deuxième sens d'écoulement (20).

10. Générateur thermoélectrique (7) selon l'une des revendications 1 à 9,
dans lequel le premier élément de contact (4) met à disposition d'un seul tenant toutes les sections de contact (41, 42, 43) ; et/ou
dans lequel le deuxième élément de contact (5) met à disposition d'un seul tenant toutes les sections de contact (51, 52, 53) ; et/ou
dans lequel la pluralité de thermocouples (3 ; 31, 32, 33) sont agencés sur une couche entre le premier canal d'écoulement (1) et le deuxième canal d'écoulement (2) ; et/ou
dans lequel le premier thermocouple (31) et le deuxième thermocouple (32) sont de même construction entre eux ou dans lequel tous les thermocouples (3 ; 31, 32, 33) de la pluralité de thermocouples (3 ; 31, 32, 33) sont de même construction entre eux ; et/ou
dans lequel le premier élément de contact (4) est un film conducteur de chaleur en graphite ou caoutchouc de silicone ou polyimide ou oxyde d'aluminium ou mica fritté ou polymère acrylique ; et/ou
dans lequel le deuxième élément de contact (5) est un film conducteur de chaleur en graphite ou caoutchouc de silicone ou polyimide ou oxyde d'aluminium ou mica fritté ou polymère acrylique.

11. Générateur thermoélectrique (7), présentant :
un canal d'écoulement (1, 2) avec une entrée (11, 21) et une sortie (12, 22) pour le guidage d'un fluide, dans lequel l'entrée (11, 21) et la sortie (12, 22) du canal d'écoulement (1, 2) définissent un sens d'écoulement (10, 20) pour le fluide ;
une pluralité de thermocouples (3' ; 31', 32', 33'), qui sont agencés de manière adjacente l'un à l'autre dans le sens d'écoulement (10, 20) à côté du canal d'écoulement (1, 2) ;
un élément de contact (4', 5') agencé entre la pluralité de thermocouples (3' ; 31', 32', 33') et une paroi du canal d'écoulement (1, 2), qui présente des sections de contact (41', 42', 43') attribuées aux différents thermocouples (3' ; 31', 32', 33'), qui mettent à disposition une liaison conductrice de chaleur entre le thermocouple (3' ; 31', 32', 33') respectivement associé et la paroi du canal d'écoulement (1, 2) ; et
**caractérisé en ce que**
l'élément de contact (4', 5') entre des sections de contact (41', 42' ; 42', 43' ; 51', 52' ; 52', 53') adjacentes, qui sont attribuées à des thermocouples (31', 32' ; 32', 33') adjacents l'un à l'autre, présente une zone de séparation (45, 55), dans laquelle la résistance thermique est au moins cinq fois supérieure à la résistance thermique moyenne des sections de contact (41', 42' ; 42', 43' ; 51', 52' ; 52', 53') adjacentes ; ou
l'élément de contact (4', 5') entre des sections de contact (41', 42' ; 42', 43' ; 51', 52' ; 52', 53') adjacentes, qui sont attribuées à des thermocouples (31', 32' ; 32', 33') adjacents l'un à l'autre, présente une zone de séparation (45, 55), dans laquelle la résistance thermique est au moins dix fois supérieure à la résistance thermique moyenne des sections de contact (41, 42 ; 51, 52) adjacentes.

12. Générateur thermoélectrique (7) selon la revendication 11,
dans lequel des thermocouples (31', 32' ; 32', 33') adjacents l'un à l'autre sont conçus pour différentes plages de températures ; et/ou
dans lequel l'élément de contact (4', 5') entre des sections de contact (41', 42' ; 42', 43' ; 51', 52' ; 52', 53') adjacentes, qui sont attribuées à des thermocouples (31', 32' ; 32', 33') adjacents l'un à l'autre, présente au moins un évidement (45, 55), dont la plus grande dimension est orientée transversalement au sens d'écoulement (10, 20).

13. Système d'échappement (8) pour un véhicule fonctionnant avec un moteur à combustion présentant un générateur thermoélectrique (7) selon l'une des revendications 1 à 12, dans lequel le premier canal d'écoulement (1) est une conduite d'échappement du système d'échappement ou est apte à être relié à une conduite d'échappement (81) du système d'échappement.

14. Élément de contact (4', 5') pour un générateur thermoélectrique (7), en particulier pour un générateur thermoélectrique (7) selon l'une des revendications 11 ou 12, dans lequel l'élément de contact (4', 5') présente une pluralité de sections de contact (41', 42', 43', 51', 52', 53'), qui sont réalisées pour mettre à disposition une liaison conductrice de chaleur entre un thermocouple (3' ; 31', 32', 33') respectivement associé d'un générateur thermoélectrique (7) et une paroi d'un canal d'écoulement (1, 2) ; et
**caractérisé en ce que**
l'élément de contact (4', 5') entre des sections de contact (41', 42' ; 42', 43' ; 51', 52' ; 52', 53') adjacentes, qui sont attribuées à des thermocouples (31', 32' ; 32', 33') adjacents l'un à l'autre, présente une zone de séparation (45, 55), dans laquelle la résistance thermique est au moins cinq fois supérieure à la résistance thermique moyenne des sections de contact (41', 42' ; 42', 43' ; 51', 52' ; 52', 53') adjacentes ; et/ou
l'élément de contact (4', 5') entre des sections de contact (41', 42' ; 42', 43' ; 51', 52' ; 52', 53') adjacentes, qui sont attribuées à des thermocouples (31', 32' ; 32', 33') adjacents l'un à l'autre, présente un évidement (45, 55) dont la plus grande dimension est orientée en direction d'une ligne de séparation entre des sections de contact (41', 42' ; 42', 43'; 51', 52'; 52', 53') adjacentes.

15. Élément de contact (4', 5') selon la revendication 14,
dans lequel l'élément de contact (4', 5') a la forme d'un rectangle avec deux côtés longs parallèles et deux côtés courts parallèles, et entre des sections de contact (41', 42' ; 42', 43' ; 51', 52'; 52', 53') adjacentes, qui sont attribuées à des thermocouples (31', 32' ; 32', 33') adjacents l'un à l'autre, un évidement (45, 55) est prévu, dont la plus grande dimension est orientée parallèlement aux côtés courts de l'élément de contact (4', 5') ; et/ou
dans lequel l'élément de contact (4', 5') met à disposition d'un seul tenant toutes les sections de contact (41', 42', 43', 51', 52', 53') ; et/ou est formé par un film conducteur de chaleur en graphite ou caoutchouc de silicone ou polyimide ou oxyde d'aluminium ou mica fritté ou polymère acrylique.
